# EUROPEAN PATENT APPLICATION

(11) **EP 4 629 796 A1**
(43) Date of publication of application: **08.10.2025**
(21) Application number: 25167616.9
(22) Date of filing: 01.04.2025
(51) Int. Cl.: H10K 59/121, H10K 59/126, H10K 59/131

(54) **DISPLAY DEVICE**

(30) Priority: 03.04.2024 KR 20240045519
(71) Applicant: Samsung Display Co., Ltd., Yongin-si, Gyeonggi-do 17113 (KR)
(72) Inventor: Kim, Wansu, 17113 Giheung-gu, Yongin-si, Gyeonggi-do (KR); Kim, Jaewon, 17113 Giheung-gu, Yongin-si, Gyeonggi-do (KR); Lee, Changyeol, 17113 Giheung-gu, Yongin-si, Gyeonggi-do (KR); Han, Jaeseok, 17113 Giheung-gu, Yongin-si, Gyeonggi-do (KR)
(74) Representative: Dr. Weitzel & Partner

(57) **Abstract**

A display device includes a first pixel circuit disposed on a substrate and a first light-emitting diode electrically connected to the first pixel circuit, the first pixel circuit includes a driving transistor including a driving semiconductor layer and a driving gate electrode, a first initialization transistor including a first initialization semiconductor layer and a first initialization gate electrode and electrically connected to the driving transistor, and a first connection electrode electrically connecting the first initialization semiconductor layer to the driving gate electrode, a semiconductor layer including the first initialization semiconductor layer includes a first extension area extending from a channel area of the first initialization semiconductor layer to the first connection electrode, and the first extension area overlaps a first shield layer disposed under the first initialization semiconductor layer and a second shield layer disposed above the first initialization semiconductor layer.

## Description

### BACKGROUND

### 1. Technical Field

The present invention relates to a display device and an electronic device including the same.

### 2. Description of the Related Art

Recently, display devices have been used for various purposes. As the range of use of display devices becomes more widespread, the demand for high-resolution display devices is increasing. In order to manufacture a high-resolution display device, it is desirable to arrange electronic elements of various structures in a narrow area.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The present invention provides a display device and an electronic device capable of displaying an image with excellent quality. The present invention is defined by the features of the independent claims. The dependent claims and the description describe preferred embodiments of the invention. However, the one or more embodiments disclosed herein are examples, and the invention is not limited thereto.

Additional aspects will be set forth in part in the description which follows and, in part, will be apparent from the description, or may be learned by practice of the presented embodiments of the invention.

According to one or more embodiments of the invention, a display device includes a first pixel circuit disposed on a substrate, and a first light-emitting diode electrically connected to the first pixel circuit, wherein the first pixel circuit includes a driving transistor comprising a driving semiconductor layer and a driving gate electrode; a first initialization transistor including a first initialization semiconductor layer and a first initialization gate electrode and electrically connected to the driving transistor; and a first connection electrode electrically connecting the first initialization semiconductor layer to the driving gate electrode, wherein the semiconductor layer including the first initialization semiconductor layer includes a first extension area extending from a channel area of the first initialization semiconductor layer to the first connection electrode, and the first extension area overlaps a first shield layer disposed under the first initialization semiconductor layer and a second shield layer disposed above the first initialization semiconductor layer.

According to one or more embodiments, the first shield layer may be disposed between an upper surface of the substrate and the driving transistor.

According to one or more embodiments, the first shield layer may overlap each of a channel area of the driving transistor and the first connection electrode.

According to one or more embodiments, the second shield layer may be disposed between the first connection electrode and the first light-emitting diode.

According to one or more embodiments, a driving voltage line may transmit a driving voltage to the first pixel circuit and extending across the first pixel circuit, wherein the second shield layer may be the driving voltage line.

According to one or more embodiments, the driving semiconductor layer and the first initialization semiconductor layer may be disposed on different layers, the driving semiconductor layer may be a silicon semiconductor layer, and the first initialization semiconductor layer may be an oxide semiconductor layer.

According to one or more embodiments, the display device may further include a second pixel circuit adjacent to the first pixel circuit in a first direction, a third pixel circuit facing the first pixel circuit with the second pixel circuit disposed between the third pixel circuit and the first pixel circuit, and a vertical voltage line disposed between the second pixel circuit and the third pixel circuit and extending in a second direction intersecting the first direction. The third pixel circuit facing the first pixel circuit especially means that the first pixel circuit and the third pixel circuit are arranged one behind another, however with the second pixel circuit in between, along a surface direction of the substrate, that is the first direction.

According to one or more embodiments, the display device may further include a second light-emitting diode electrically connected to the second pixel circuit and a third light-emitting diode electrically connected to the third pixel circuit, wherein the first light-emitting diode emits red light, the second light-emitting diode emits green light, and the third light-emitting diode emits blue light.

According to one or more embodiments, the vertical voltage line and the second shield layer may be disposed on a same layer.

According to one or more embodiments, the display device may further include a horizontal voltage line electrically connected to the vertical voltage line and extending in the first direction and a bridge pattern electrically connecting the vertical voltage line to the horizontal voltage line, wherein the bridge pattern and the first connection electrode may be disposed on a same layer.

According to one or more embodiments, the third pixel circuit may include a silicon semiconductor layer and an oxide semiconductor layer, and, the oxide semiconductor layer of the third pixel circuit may be spaced apart from the bridge pattern when viewed from a direction vertical to the substrate.

According to one or more embodiments, the third pixel circuit may further include a driving transistor, a compensation transistor including a compensation semiconductor layer and a compensation gate electrode and electrically connected to the driving transistor, an emission control transistor including an emission control semiconductor layer and an emission control gate electrode and electrically connected to the driving transistor, and a second connection electrode electrically connecting the compensation transistor to the driving transistor and the compensation transistor to the emission control transistor, wherein a semiconductor layer including the compensation semiconductor layer may include a second extension area extending from a drain area of the compensation semiconductor layer to the second connection electrode, and the bridge pattern and the second extension area may be spaced apart from each other.

According to one or more embodiments, the first pixel circuit may further include a compensation transistor including a compensation semiconductor layer and a compensation gate electrode and electrically connected to the driving transistor, wherein the first initialization semiconductor layer and the compensation semiconductor layer may be integral with each other.

According to one or more embodiments, a ratio (W/L) of a channel width to a channel length of the first initialization transistor may be different from a ratio (W/L) of a channel width to a channel length of the compensation transistor.

According to one or more embodiments, a channel length of the compensation transistor may be greater than a channel length of the first initialization transistor.

According to one or more embodiments of the invention, a display device includes a first pixel circuit disposed on a substrate; a second pixel circuit adjacent to the first pixel circuit in a first direction; a third pixel circuit facing the first pixel circuit with the second pixel circuit disposed between the third pixel circuit and the first pixel circuit; a vertical voltage line disposed in a gap area between the second pixel circuit and the third pixel circuit and extending in a second direction intersecting the first direction; a horizontal voltage line electrically connected to the vertical voltage line and extending in the first direction; and a bridge pattern electrically connecting the vertical voltage line to the horizontal voltage line, wherein the third pixel circuit includes a silicon semiconductor layer and an oxide semiconductor layer, and the oxide semiconductor layer is spaced apart from the bridge pattern when viewed from a direction vertical to the substrate.

According to one or more embodiments, the display device may further include a first light-emitting diode electrically connected to the first pixel circuit, a second light-emitting diode electrically connected to the second pixel circuit, and a third light-emitting diode electrically connected to the third pixel circuit, wherein the first light-emitting diode may emit red light, the second light-emitting diode may emit green light, and the third light-emitting diode may emit blue light.

According to one or more embodiments, each of the first pixel circuit, the second pixel circuit, and the third pixel circuit may include a driving transistor including a driving gate electrode and a driving semiconductor layer included in the silicon semiconductor layer, a first initialization transistor including a first initialization gate electrode and a first initialization semiconductor layer included in the oxide semiconductor layer, the first initialization transistor being electrically connected to the driving transistor, and a first connection electrode electrically connecting the first initialization semiconductor layer to the driving gate electrode, wherein the oxide semiconductor layer may include a first extension area extending from a channel area of the first initialization semiconductor layer to the first connection electrode, and the first extension area may overlap a first shield layer disposed under the oxide semiconductor layer and a second shield layer disposed above the oxide semiconductor layer.

According to one or more embodiments, the first shield layer may be a lower metal layer disposed between an upper surface of the substrate and the driving transistor.

According to one or more embodiments, the display device may further include a driving voltage line disposed on a same layer as the vertical voltage line and may be spaced apart from the vertical voltage line, wherein the second shield layer may be the driving voltage line.

According to one or more embodiments, each of the first pixel circuit, the second pixel circuit, and the third pixel circuit may further include a compensation transistor including a compensation gate electrode and a compensation semiconductor layer included in the oxide semiconductor layer, the compensation transistor being electrically connected to the driving transistor, wherein a ratio (W/L) of a channel width to a channel length of the first initialization transistor may be different from a ratio (W/L) of a channel width to a channel length of the compensation transistor.

According to one or more embodiments of the invention, an electronic apparatus includes a display device as described herein.

### BRIEF DESCRIPTION OF THE DRAWINGS

The above and other aspects, features, and advantages of embodiments of the invention will be more apparent from the following description taken in conjunction with the accompanying drawings, in which:
FIG. 1 is a schematic plan view of a display device according to an embodiment;
FIG. 2 is a schematic block diagram of the display device according to an embodiment;
FIG. 3 is a schematic diagram of an equivalent circuit of a pixel in the display device according to an embodiment;
FIG. 4 is a schematic diagram of an equivalent circuit of a number of pixels in the display device according to an embodiment;
FIG. 5 is a schematic view of a number of wirings disposed in a display area of the display device according to an embodiment;
FIG. 6 is a schematic plan view of a portion of the display area of the display device according to an embodiment;
FIG. 7 is a schematic plan view illustrating first to third pixel circuits of the display device according to an embodiment;
FIGS. 8 to 18 are schematic plan views showing a process of forming the first to third pixel circuits shown in FIG. 7;
FIGS. 19 and 20 are enlarged schematic plan views of a portion of the display device according to an embodiment;
FIG. 21 is a schematic plan view of the display device according to an embodiment; and
FIG. 22 is an enlarged schematic plan view of a portion of the display device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are described below, by referring to the figures, to explain aspects of the description.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Because the invention may have diverse modified embodiments, embodiments are illustrated in the drawings and are described in the detailed description. An effect and a characteristic of the invention, and a method of accomplishing these will be apparent when referring to embodiments described with reference to the drawings. The invention may, however, be embodied in many different forms and should not be construed as limited to the embodiments set forth herein.

Hereinafter, embodiments will be described in detail with reference to the accompanying drawings, wherein the same or corresponding elements are denoted by the same reference numerals throughout and a repeated description thereof may be omitted.

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the invention.

As used herein, the singular forms, "a," "an," and "the" are intended to include the plural forms as well, unless the context clearly indicates otherwise.

It will be understood that the terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

It will be understood that when a layer, region, or element is referred to as being formed "on" another layer, area, or element, it can be directly or indirectly formed on the other layer, region, or element. For example, intervening layers, regions, or elements may be present.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

In the drawings, for convenience of description, sizes of components may be exaggerated or reduced. In other words, since sizes and thicknesses of elements in the drawings are arbitrarily illustrated for convenience of description, the following embodiments are not limited thereto.

When an embodiment may be implemented differently, a specific process order may be performed differently from the described order. For example, two consecutively described processes may be performed substantially at the same time or performed in an order opposite to the described order.

In the embodiments hereinafter, it will be understood that when an element, an area, or a layer is referred to as being connected to another element, area, or layer, it can be directly and/or indirectly connected to the other element, area, or layer. For example, it will be understood in this specification that when an element, an area, or a layer is referred to as being in contact with or being electrically connected to another element, area, or layer, it can be **directly** and/or indirectly in contact with or electrically connected to the other element, area, or layer.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

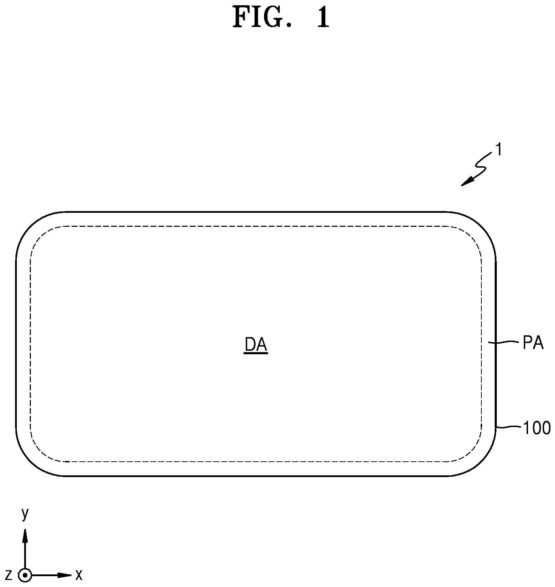

FIG. 1 is a schematic plan view of a display device according to an embodiment;

Referring to FIG. 1, a display device 1 may include a display area DA for displaying an image and a peripheral area PA outside of the display area DA. The display area DA may be entirely surrounded by or may be adjacent to the peripheral area PA.

In a plan view, the display area DA may have an approximately rectangular shape with rounded corners. In an embodiment, the display area DA may have a polygonal shape such as a triangular, quadrilateral, pentagonal, or hexagonal shape or may have a circular, elliptical, or atypical shape.

The display device 1 of FIG. 1 may be capable of displaying moving images or stationary images and may be used in portable electronic devices such as mobile laptops, tablet personal computers (PC), mobile phones, smart phones, mobile communication terminals, electronic note functions, electronic books, portable multimedia players (PMP), navigation, ultra mobile PCs (UMPC). By way of example, the display device 1 may be used for televisions, monitors, billboards, electronic devices for Internet of Things (IOT), or wearable electronic equipment such as smart watches, watch phones, glasses-type displays, and head mounted displays (HMD). The display device 1 according to an embodiment may be used in a vehicle dashboard, a center information display (CID) arranged (or disposed) in a center fascia or dashboard of a vehicle, a room mirror display replacing a side mirror of a vehicle, and electronic equipment for display as an entertainment in the back seat of a vehicle, the electronic equipment being arranged (or disposed) in the rear surface of a front seat.

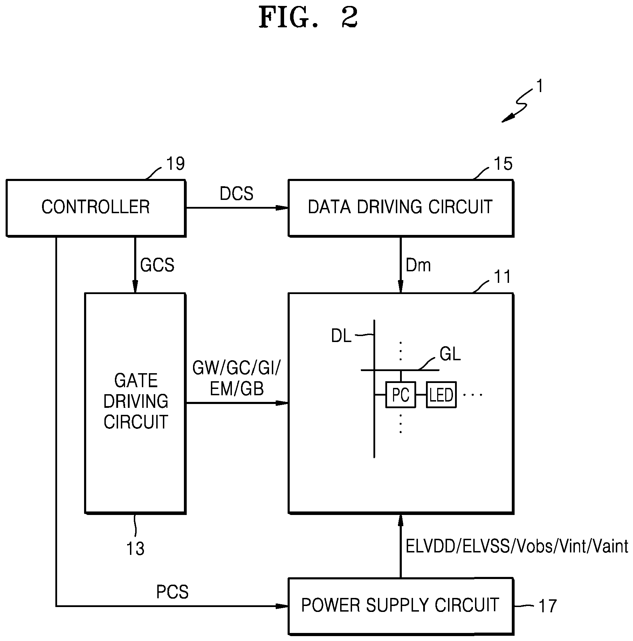

FIG. 2 is a schematic block diagram of the display device 1 according to an embodiment.

Referring to FIGS. 1 and 2, the display device 1 according to an embodiment may include a pixel portion 11, a gate driving circuit 13, a data driving circuit 15, a power supply circuit 17, and a controller 19.

The pixel portion 11 may include pixels arranged (or disposed) in the display area DA (refer to FIG. 1). The pixels may be arranged in various forms such as a stripe arrangement, a PENTILE^{™} arrangement (a diamond arrangement), a mosaic arrangement, etc. to display an image. Each pixel may emit light through a light-emitting diode LED and each light-emitting diode LED may be electrically connected to a pixel circuit PC. Each pixel circuit PC may be electrically connected to the gate line GL and the data line DL and may include transistors T1, T2, T3, T4, T5, T6, T7, and T8 (hereinafter, also referred to as a driving transistor T1, a data write transistor T2, a compensation transistor T3, a first initialization transistor T4, an operation control transistor T5, an emission control transistor T6, a second initialization transistor T7, and a bias transistor T8) and at least one capacitor.

Various conductive lines configured to transmit electrical signals to be applied to the display area DA, peripheral circuits electrically connected to the pixel circuits, and pads onto which a printed circuit board or a driver IC chip is attached are arranged in the peripheral area PA (refer to FIG. 1). For example, a gate driving circuit 13, a data driving circuit 15, a power supply circuit 17, and a controller 19 may be arranged in the peripheral area PA (refer to FIG. 1).

The gate driving circuit 13 may be electrically connected to gate lines GL, may generate a gate signal in response to a control signal GCS from the controller 19, and sequentially supply the gate signal to the gate lines GL. The gate signal may be a gate control signal configured to control the turn-on and turn-off of a transistor electrically connected to the gate line GL. The gate signal may be a square wave signal with an on voltage that may turn on the transistor and an off voltage that may turn off the transistor. In an embodiment, the on voltage may be a high-level voltage (a first level voltage) or a low-level voltage (a second level voltage).

FIG. 2 illustrates that one pixel circuit PC is connected to one gate line GL, but this is just an example, and one pixel circuit PC may be connected to two or more gate lines, and the gate driving circuit 13 may supply at least two gate signals with different timings at which the "on" voltage is applied to the corresponding gate lines. For example, the pixel circuit PC may be electrically connected to the gate lines, and the gate driving circuit 13 may respectively apply a scan signal GW, a first initialization control signal GI, a second initialization control signal GB, a compensation scan signal GC, and an emission control signal EM to the pixel circuit PC through the gate lines.

The data driving circuit 15 may be connected to the data lines DL and may supply a data signal Dm to the data lines DL in response to a control signal DCS from the controller 19. The data signal Dm supplied by the data line DL may be supplied to the pixel circuit PC. The data driving circuit 15 may convert an input image data including a grading input from the controller 19 to a voltage or current type data signal Dm.

The power supply circuit 17 may generate voltages desirable for the driving of the pixel circuit PC and the light-emitting diode LED in response to a control signal PCS from the controller 19. The power supply circuit 17 may generate and respectively supply a driving voltage ELVDD and a common voltage ELVSS to the pixel circuit PC and the light-emitting diode LED. The driving voltage ELVDD may be a high-level voltage supplied to the first electrode (or a pixel electrode or an anode) of the light-emitting diode LED. The common voltage ELVSS may be a low-level voltage supplied to the second electrode (or a counter electrode or a cathode) of the light-emitting diode LED. The power supply circuit 17 may generate and supply a bias voltage Vobs, a first initialization voltage Vint, and a second initialization voltage Vint to the pixel circuit PC.

The voltage level of the driving voltage ELVDD may be greater than the voltage level of the common voltage ELVSS. The voltage level of the first initialization voltage Vint and the second initialization voltage Vaint may be greater than the voltage level of the common voltage ELVSS. The voltage level of the bias voltage Vobs may be greater than the voltage level of the driving voltage ELVDD.

The controller 19 may generate a control signal GCS, DCS, and PCS based on signals input from the outside and may supply the control signal GCS, DCS, and PCS to the gate driving circuit 13, the data driving circuit 15, and the power supply circuit 17. The control signal GCS output to the gate driving circuit 13 may include clock signals and a gate initiation signal. The control signal DCS output to the data driving circuit 15 may include a source initiation signal and clock signals.

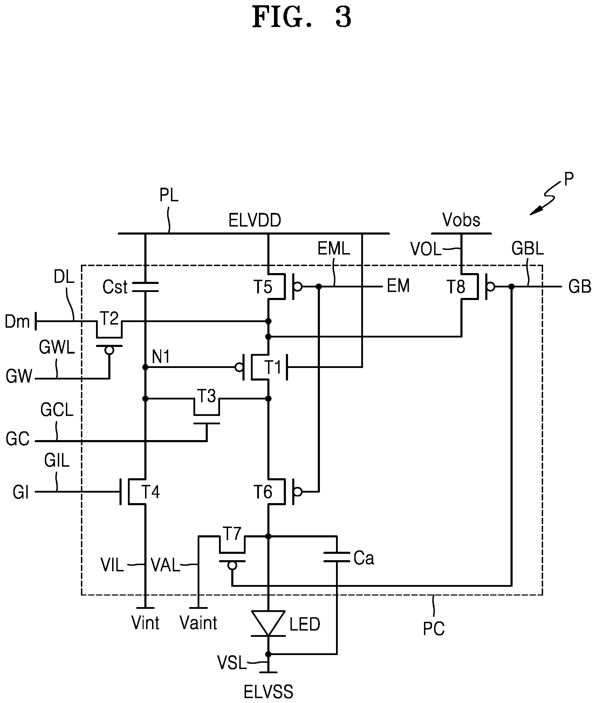

FIG. 3 is a schematic diagram of an equivalent circuit of a pixel in the display device according to an embodiment.

FIG. 3 is a schematic diagram of an equivalent circuit of one of the light-emitting diodes and one of the pixel circuits arranged in the display device according to an embodiment

Referring to FIG. 3, the pixel circuit PC may be connected to each of the gate lines, such as a scan line GWL, a first initialization control line GIL, a second initialization control line GBL, a compensation scan line GCL, and an emission control line EML, and thus may receive the scan signal GW, the first initialization signal GI, the second initialization control signal GB, the compensation scan signal GC, and the emission control signal EM. For example, the scan line GWL, the first initialization control line GIL, the second initialization control line GBL, the compensation scan line GCL, and the emission control line EML may be gate lines connected to the pixel circuit PC arranged in the ith (i is a natural number) row.

The pixel circuit PC may receive a data signal Dm through the data line DL. For example, the data line DL of FIG. 3 may be a signal line connected to the pixel circuit PC arranged in the jth (j is a natural number) row.

The pixel circuit PC of the display device according to the embodiment may be electrically connected to the light-emitting diode LED emitting a selectable color of light, and the light-emitting diode LED may include the first electrode (a pixel electrode and anode), the second electrode (a counter electrode and cathode), and intermediate layer between the first electrode and the second electrode.

The pixel circuit PC may include transistors T1, T2, T3, T4, T5, T6, T7, and T8, and capacitors Cst and Ca. The transistors T1, T2, T3, T4, T6, T6, T7, and T8 may include a driving transistor T1, a data write transistor T2, a compensation transistor T3, a first initialization transistor T4, an operation control transistor T5, an emission control transistor T6, a second initialization transistor T7, and a bias transistor T8. The capacitors Cst and Ca may include the first capacitor Cst and the second capacitor Ca.

In an embodiment, a number of the transistors T1, T2, T3, T4, T5, T6, T7, and T8 may be p-channel MOSFETs (PMOS), and the other transistors may be n-channel MOSFETs (NMOS). For example, among the transistors T1, T2, T3, T4, T5, T6, T7, and T8, the driving transistor T1, the data write transistor T2, the operation control transistor T5, the emission control transistor T6, the second initialization transistor T7, and the bias transistor T8 may be PMOS, and the compensation transistor T3 and the first initialization transistor T4 may be NMOS. By way of example, among the transistors T1, T2, T3, T4, T5, T6, T7, and T8, the compensation transistor T3 and the first initialization transistor T4 may be PMOS and the others may be NMOS. By way of example, all of the transistors T1, T2, T3, T4, T5, T6, T7, and T8 may be NMOS or PMOS. Hereinafter, embodiments wherein the compensation transistor T3 and the first initialization transistor T4 are NMOS including an oxide semiconductor and the others are PMOS are described.

At least one of the transistors T1, T2, T3, T4, T5, T6, T7, and T8 may include a low-temperature polycrystalline silicon (LTPS) semiconductor layer and at least one of the transistors T1, T2, T3, T4, T5, T6, T7, and T8 may include an oxide semiconductor layer.

In case that a semiconductor layer including highly-reliable polycrystalline silicon is included in the driving transistor T1 that directly affects a brightness of the display device, a high-resolution display device may be implemented. An oxide semiconductor has high carrier mobility and low leakage current, and thus, a voltage drop is not large even in case that a driving time is long. For example, since a color change in images according to the voltage drop is not noticeable even during a low-frequency operation, the display device may operate at a low frequency. Since the oxide semiconductor has a low leakage current, by using at least one of the compensation transistor T3 and the first initialization transistor T4 that are connected to the driving gate electrode of the driving transistor T1 as an oxide semiconductor, leakage current that may flow through the driving gate electrode may be prevented and, at the same time, power consumption may be reduced. For example, the driving transistor T1, the data write transistor T2, the operation control transistor T5, the emission control transistor T6, the second initialization transistor T7, and the bias transistor T8 may include a low-temperature polysilicon semiconductor layer, and the compensation transistor T3 and the first initialization transistor T4 may include an oxide semiconductor layer.

The driving transistor T1 may be connected between the driving voltage line (or vertical driving voltage line PL), which is configured to supply the driving voltage ELVDD, and the light-emitting diode LED. The gate electrode of the driving transistor T1 may be connected to an end of the first capacitor Cst, which is a storage capacitor. The gate electrode of the driving transistor T1 may be connected to a first node N1. The source electrode of the driving transistor T1 may be connected to the driving voltage line PL via the operation control transistor T5. The drain electrode of the driving transistor T1 may be electrically connected to the pixel electrode (for example, an anode) of the light-emitting diode LED (for example, an anode) via the emission control transistor T6. The driving transistor T1 may receive the data signal Dm received from the data line DL and supply a driving voltage to the light-emitting diode LED according to a switching operation of the data write transistor T2.

The gate electrode of the data write transistor T2 may be connected to the scan line GWL. The first electrode of the data write transistor T2 may be connected to the data line DL and the second electrode may be connected to the source electrode of the driving transistor T1. The data write transistor T2 may be turned on in response to the scan signal GW received from the scan line GWL and may be configured to transmit the data signal Dm received from the data line DL to the source electrode of the driving transistor T1, and simultaneously transmit the data signal Dm to the gate electrode of the driving transistor T1 through the compensation transistor T3 that is turned on.

The gate electrode of the compensation transistor T3 may be connected to the compensation scan line GCL. The first electrode of the compensation transistor T3 may be connected to the drain electrode of the driving transistor T1, and the second electrode may be connected to the first node N1. The compensation transistor T3 may be turned on through the compensation scan signal GC received from the compensation scan line GCL so as to connect the gate electrode of the driving transistor T1 to the drain electrode of the driving transistor T1, thereby diode-connecting the driving transistor T1 and thus compensating for a threshold voltage Vth of the driving transistor T1.

The gate electrode of the first initialization transistor T4 may be connected to the first initialization control line GIL. The first electrode of the first initialization transistor T4 may be connected to the first initialization voltage line VIL and the second electrode may be connected to the first node N1. The first initialization transistor T4 may be turned on according to the first initialization control signal GI applied by the first initialization control line GIL and may be configured to transmit the first initialization voltage Vint to the gate electrode of the driving transistor T1, thereby initializing a potential (for example a potential of the first node N1) of the gate electrode of the driving transistor T1. The first initialization voltage Vint may have a voltage level higher than the common voltage ELVSS or may have a voltage level equal to the common voltage ELVSS.

The gate electrode of the operation control transistor T5 may be connected to the emission control line EML. The first electrode of the operation control transistor T5 may be connected to the driving voltage line PL and the second electrode may be connected to the source electrode of the driving transistor T1.

The gate electrode of the emission control transistor T6 may be connected to the emission control line EML. The first electrode of the emission control transistor T6 may be connected to the drain electrode of the driving transistor T1 and the second electrode may be electrically connected to the pixel electrode of the light-emitting diode LED. The operation control transistor T5 and the emission control transistor T6 may be simultaneously turned on according to the emission control signal EM applied by the emission control line EML. The driving voltage ELVDD applied through the turned-on operation control transistor T5 may be compensated by the driving transistor T1 and transmitted to the light-emitting diode LED.

The gate electrode of the second initialization transistor T7 may be connected to the second initialization control line GBL. The first electrode of the second initialization transistor T7 may be connected to the pixel electrode of the light-emitting diode LED, and the second electrode may be connected to a second initialization voltage line VAL. The second initialization transistor T7 may be turned on through the second initialization control signal GB applied by the second initialization control line GBL and initialize the pixel electrode of the light-emitting diode LED. The second initialization control signal GB may be the same signal as the first initialization control signal GI or may be a different signal.

As a comparative example of the invention, in case that the light-emitting diode LED emits light even in case that a minimum current of the driving transistor T1 for displaying a black image flows into the driving current, the black image may not be displayed appropriately. However, according to the invention, the second initialization transistor T7 may disperse some of the minimum current of the driving transistor T1 to a current path other than the current path of the light-emitting diode LED as a bypass current. Here, the minimum current of the driving transistor T1 may refer to a current in a condition in which a gate-source voltage Vgs of the driving transistor T1 is less than the threshold voltage Vth, thereby causing the driving transistor T1 to be turned off. Accordingly, the minimum driving current (for example, a current of about 10 picoampere (pA) or less) in a condition in which the driving transistor T1 is turned off may be transmitted to the light-emitting diode LED and expressed as a black luminance image. In case that the minimum driving current for displaying the black image flows, the effect of the bypass transfer of the bypass current is large but in case that a large driving current for displaying an image such as a general image or a white image flows, an effect of the bypass current may be very much less. Therefore, in case that the driving current displaying the black image flows, the accurate black luminance image may be achieved by the driving current by using the first initialization transistor T7 to improve the contrast ratio. Accordingly, a display device with improved display quality may be provided.

The gate electrode of the bias transistor T8 may be connected to the second initialization control line GBL. The first electrode of the bias transistor T8 may be connected to a bias voltage line VOL to which the bias voltage Vobs is supplied and the second electrode of the bias transistor T8 may be connected to the source electrode of the driving transistor T1.

An end of the first capacitor Cst may be connected to the gate electrode of the driving transistor T1 and the other end of the first capacitor Cst may be connected to the driving voltage line PL. The first capacitor Cst may be connected between the driving voltage line PL and the first node N1. The first capacitor Cst may be configured to store a voltage between the driving voltage ELVDD and the first node N1.

The second capacitor Ca is an auxiliary electrode and may be electrically connected to the first electrode of the emission control transistor T6, the second initialization transistor T7, and the light-emitting diode LED. The second capacitor Ca may store and maintain a voltage corresponding to a voltage difference between the first electrode of the light-emitting diode LED and the common voltage line VSL while the second initialization transistor T7 is turned on, thereby preventing a black luminance from being increased in case that the emission control transistor T6 is turned off.

The pixel electrode of the light-emitting diode LED may receive a driving current from the driving transistor T1 and display an image by emitting light. The driving voltage ELVDD may be a selectable high-level voltage, and the common voltage ELVSS may be less than the driving voltage ELVDD.

Hereinafter, an operation process of the pixel circuit PC and the light-emitting diode LED is described.

During an initialization period, a low-level first initialization control signal GI may be supplied to the first initialization transistor T4 through the first initialization control line GIL and a low-level second initialization control signal GB may be supplied to the second initialization transistor T7 through the second initialization control line GBL. As a result, the first initialization transistor T4 and the second initialization transistor T7 may each be turned on. The first initialization voltage Vint applied by the first initialization voltage line VIL may be transmitted to the gate electrode of the driving transistor T1 through the first initialization transistor T4 and the second initialization voltage Vaint applied by the second initialization voltage line VAL may be transmitted to an anode of the light-emitting diode LED through the second initialization transistor T7. Accordingly, the voltage of the gate electrode and the anode of the driving transistor T1 may be initialized.

Thereafter, during a data write period, a low-level scan signal GW may be supplied through the scan line GWL and a high-level compensation scan signal GC may be supplied through the compensation scan line GCL and the data write transistor T2 and the compensation transistor T3 may be turned on. The data write transistor T2 may be configured to transmit the data signal Dm from the data line DL to the source electrode of the driving transistor T1 and the driving transistor T1 may be diode-connected by the compensation transistor T3. Accordingly, a compensation voltage reduced as much as the threshold voltage of the driving transistor T1 from the data signal Dm may be applied to the gate electrode of the driving transistor T1.

The driving voltage ELVDD and the compensation voltage may be respectively applied to opposite ends of the first capacitor Cst, and a charge corresponding to a voltage difference between the opposite ends of the first capacitor Cst may be stored in the first capacitor Cst.

Thereafter, during an emission period, the emission control signal EM supplied from the emission control line EML may be changed from a high level to a low level, and the operation control transistor T5 and the emission control transistor T6 may be turned on. Accordingly, a driving current corresponding to a voltage difference between the voltage of the gate electrode of the driving transistor T1 and the driving voltage ELVDD may be generated, and the driving current may be supplied to the light-emitting diode LED through the emission control transistor T6, thereby emitting light.

The characteristic of the light-emitting diode LED emitting different light and/or the characteristic of the driving transistor T1 of each of the pixel circuits PC may be different. For example, the color coordinate of the display device 1 may be changed during high-frequency driving. However, according to the invention, the voltage of the source electrode of the driving transistor T1 may be controlled through the bias voltage Vobs through the bias transistor T8. Accordingly, the driving current may be controlled, thereby improving a luminance deviation (a current deviation) and a color coordinate change of each pixel. Accordingly, a display device with improved display quality may be provided.

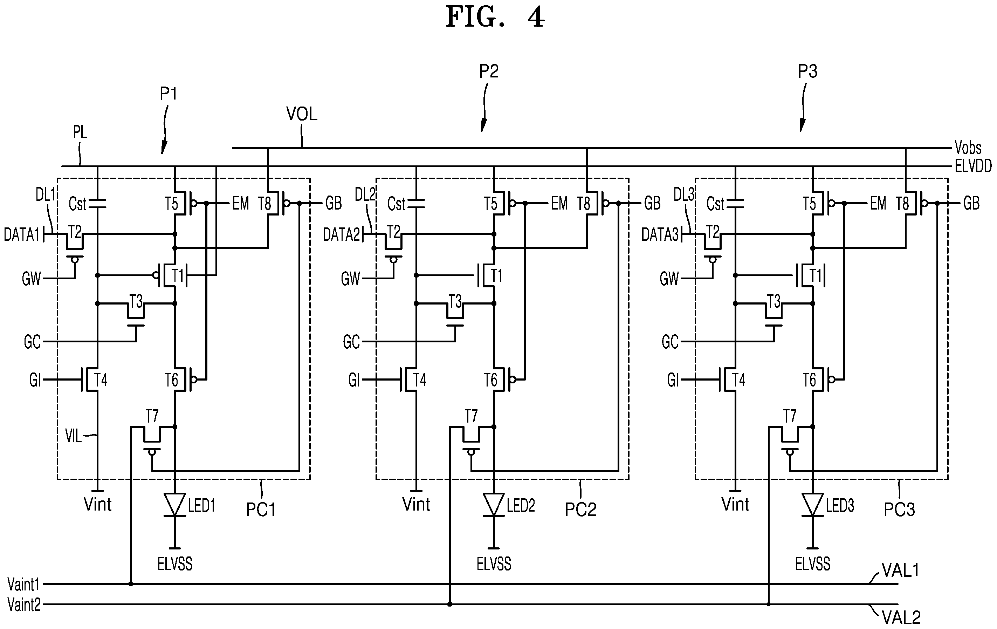

FIG. 4 is a schematic diagram of an equivalent circuit of a number of pixels in the display device according to an embodiment. The pixels P (FIG. 3) may include a first pixel P1, a second pixel P2, and a third pixel P3 emitting light of different colors. FIG. 4 is a schematic diagram of an equivalent circuit illustrating the first pixel P1, the second pixel P2, and the third pixel P3 emitting light of different colors. In describing FIG. 4, the descriptions that are the same as those of the elements of FIG. 3 may be omitted and differences are described.

Referring to FIG. 4, the first pixel P1, the second pixel P2, and the third pixel P3 may share one of the gate lines GL (FIG. 1). The first pixel P1 may be electrically connected to a first data line DL1, which is one of the data lines DL. The second pixel P2 may be electrically connected to a second data line DL2, which is another one of the data lines DL. The third pixel P3 may be electrically connected to a third data line DL3, which is another one of the data lines DL3.

The first pixel P1 may include a first pixel circuit PC1 and a first light-emitting diode LED1. The second initialization transistor T7 of the first pixel circuit PC1 may be connected between a second-1 initialization voltage line VAL1 and an anode of the first light-emitting diode LED1 and receive the second initialization control signal GB. The first pixel P1 may emit light of a first color. For example, light of the first color may be red light.

The second pixel P2 may include a second pixel circuit PC2 and a second light-emitting diode LED2. The second initialization transistor T7 of the second pixel circuit PC2 may be connected between a second-2 initialization voltage line VAL2 and an anode of the second light-emitting diode LED2 and receive the second initialization control signal GB. The second pixel P2 may emit light of a second color, which is different from the first color. For example, light of the second color may be green light.

The third pixel P3 may include a third pixel circuit PC3 and a third light-emitting diode LED3. The second initialization transistor T7 of the third pixel circuit PC3 may be connected between a second-2 initialization voltage line VAL2 and an anode of the third light-emitting diode LED3 and receive the second initialization control signal GB. The third pixel P3 may emit light of a third color different from the first and second colors. For example, light of the third color may be blue light.

The second-1 initialization voltage Vaint1 may be applied to the second-1 initialization voltage line VAL1. A second-2 initialization voltage Vaint2 may be applied to the second-2 initialization voltage line VAL2. The second-1 initialization voltage Vaint1 may have a level less than the second-2 initialization voltage Vaint2. In an embodiment, the second-1 initialization voltage Vaint1 may have a similar level with the second-2 initialization voltage Vaint2.

The first pixel circuit PC1 of the first pixel P1 may be connected to the second-1 initialization voltage line VAL1 to which the second-1 initialization voltage Vaint1 is supplied. The first pixel circuit PC1 may be electrically connected to the first light-emitting diode LED1 emitting light of the first color. The second pixel circuit PC2 of the second pixel P2 may be connected to the second-2 initialization voltage line VAL2 to which the second-2 initialization voltage Vaint2 is supplied. The second pixel circuit PC2 may be electrically connected to the second light-emitting diode LED2 emitting light of the second color. The third pixel circuit PC3 of the third pixel P3 may be connected to the second-2 initialization voltage line VAL2 to which the second-2 initialization voltage Vaint2 is supplied. The third pixel circuit PC3 may be electrically connected to the third light-emitting diode LED3 emitting light of the third color. For example, the initialization voltages Vaint1 and Vaint2 may be supplied differently according to the type of the pixel.

FIG. 4 illustrates that the first pixel circuit PC1 is connected to the first initialization voltage line VAL1 and the second pixel circuit PC2 and the third pixel circuit PC3 are connected to the second initialization voltage line VAL2. However, the initialization voltage supplied to each of the first pixel circuit PC1, the second pixel circuit PC2, and the third pixel circuit PC3, according to an embodiment, is not limited thereto. For example, different initialization voltage lines may be connected or different initialization voltages may be supplied to the first pixel circuit PC1, the second pixel circuit PC2, and the third pixel circuit PC3. FIG. 4B also includes DATA1, DATA2, and DATA3 with respect to the data write transistor T2.

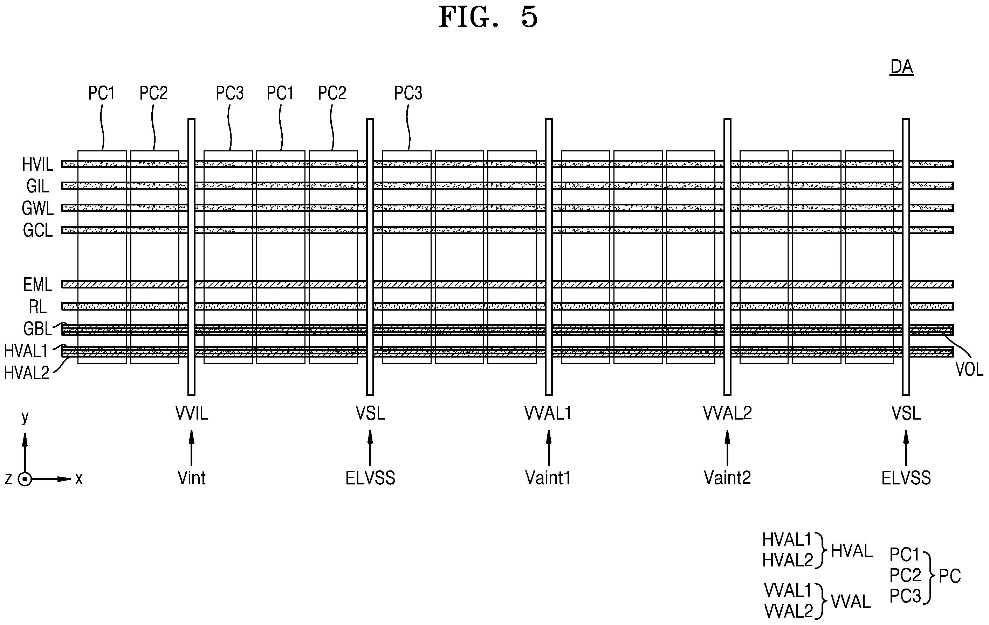

FIG. 5 is a schematic plan view of portions of wirings arranged in the display area DA of the display device according to an embodiment. The pixel circuits PC may be arranged in the first direction (for example, the ± x direction) and the second direction (for example, the ± y direction) in the display area DA, and FIG. 5 illustrates the pixel circuits PC arranged in the same row, for example, the ith row. FIG. 5 also includes a third direction, the z direction.

The pixel circuits PC may be respectively and electrically connected to the light-emitting diodes LED. Hereinafter, for convenience of description, the pixel circuits PC, respectively and electrically connected to the first to third light-emitting diodes LED1 to LED3 emitting different colors of light, are described as the first to third pixels circuits PC1, PC2, and PC3.

The first pixel circuit PC1 may be electrically connected to the first light-emitting diode LED1 emitting light of the first color, the second pixel circuit PC2 may be electrically connected to the second light-emitting diode LED2 emitting light of the second color, and the third pixel circuit PC3 may be electrically connected to the third light-emitting diode LED3 emitting light of the third color. In an embodiment, the first color, the second color, and the third color are different colors and may be selected from red, green, and blue.

The first to third pixel circuits PC1, PC2, and PC3 may be repeatedly arranged along the first direction (for example, the ±x direction). The first pixel circuit PC1, the second pixel circuit PC2, and the third pixel circuit PC3 may be arranged in a first direction (for example, ±x direction), and a distance between the second pixel circuit PC2 and the third pixel circuit PC3 may be greater than a distance between the second pixel circuit PC2 and the first pixel circuit PC1.

Lines that are electrically connected to the pixel circuits PC, such as first conductive lines (hereinafter referred to as horizontal conductive lines) extending along the first direction (for example, the ± x direction) and second conductive lines (hereinafter referred to as vertical conductive lines) extending along the second direction (for example, the ±y direction), may be arranged in the display area DA.

The horizontal conductive lines extending along the first direction (for example, the ±x direction) may include a first initialization horizontal voltage line HVIL, the first initialization control line GIL, the scan line GWL, the compensation scan line GCL, the emission control line EML, a repair line RL, the second initialization control line GBL, a bias voltage line VOL, and a second initialization horizontal voltage line HVAL. The second initialization horizontal voltage line HVAL may include a second-1 initialization horizontal voltage line HVAL1 and a second-2 initialization horizontal voltage line HVAL2.

The vertical conductive lines extending along the second direction (for example, ±y direction) may include a first initialization vertical voltage line VVIL, the common voltage line VSL configured to supply the common voltage ELVSS (FIG. 3), and a second initialization vertical voltage line VVAL. The second initialization vertical voltage line VVAL may include a second-1 initialization vertical voltage line VVAL1 and a second-2 initialization vertical voltage line VVAL2.

The first initialization vertical voltage line VVIL and the first initialization horizontal voltage line HVIL configured to supply the first initialization voltage Vint may be electrically connected to each other in the display area DA. The second-1 initialization horizontal voltage line HVAL1 and the second-1 initialization vertical voltage line VVAL1 configured to supply the second-1 initialization voltage Vaint1 to the first pixel circuit PC1 may be electrically connected to each other in the display area DA. The second-2 initialization vertical voltage line VVAL2 and the second-2 initialization horizontal voltage line HVAL2 configured to supply the second-2 initialization voltage Vaint2 to the second pixel circuit PC2 and the third pixel circuit PC3 may be connected to each other in the display area DA.

FIG. 5 illustrates that the second pixel circuit PC2 and the third pixel circuit PC3 are connected to the same voltage line, for example, the second-2 initialization vertical voltage line VVAL2 and/or the second-2 initialization horizontal voltage line HVAL2. However, the invention is not limited thereto. In an embodiment, the horizontal and vertical voltage lines for applying the second initialization voltage to the second pixel circuit PC2 and the horizontal and vertical voltage lines for applying the second initialization voltage to the third pixel circuit PC2 may be independently present.

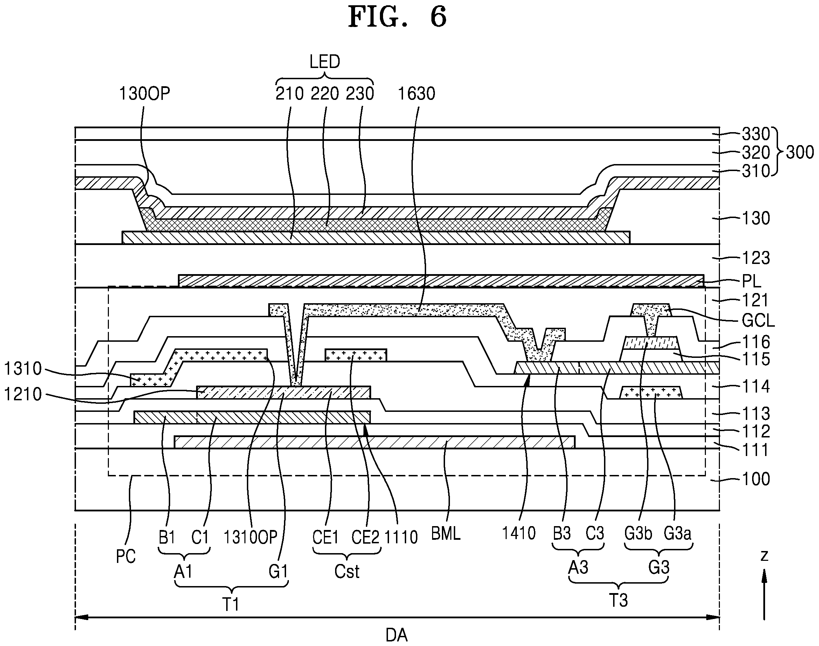

FIG. 6 is a schematic plan view of a portion of the display area DA of the display device 1 according to an embodiment.

Referring to FIG. 6, the pixel circuit PC may be disposed on the substrate 100 and the light-emitting diode LED may be disposed on the pixel circuit PC.

The substrate 100 may include a material including a glass material, a ceramic material, a metal material, a plastic material, or a flexible or bendable material. In case that the substrate 100 has flexible or bendable characteristics, the substrate 100 may include polymer resin, such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate, and cellulose acetate propionate (CAP).

The substrate 100 may have a single or multi-layer structure including the above material and may further include an inorganic layer in case that having a multi-layer structure. For example, the substrate 100 may include a first organic base layer, a first inorganic barrier layer, a second organic base layer, and a second inorganic barrier layer. The first organic base layer and the second organic base layer may each include polymer resin. The first inorganic barrier layer and the second inorganic barrier layer may be barrier layers that prevent the penetration of an external foreign material and may be a single layer or multiple layers including silicon nitride and/or silicon oxide.

A lower metal layer BML may be disposed on the substrate 100. The lower metal layer BML may include at least one material selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu). In an embodiment, the lower metal layer BML may have a single layer including Mo, a two-layer structure in a Mo layer and a Ti layer are stacked, and a three-layer structure in which a Ti layer, an Al layer, and a Ti layer are stacked.

The lower metal layer BML may have a voltage level of a constant voltage. For example, the lower metal layer BML may be electrically connected to the driving voltage line PL described with reference to FIG. 3 and may have the same voltage level (for example, a driving voltage ELVDD (FIG. 3) as the driving voltage line PL. The lower metal layer BML may prevent the (-) charge from being accumulated in the lower portion of the semiconductor layer (hereinafter referred to as a first semiconductor layer or a driving semiconductor layer A1) and may prevent or minimize the (-) charges from causing an image sticking. In case that viewed from a direction perpendicular to an upper surface of the substrate 100, the lower metal layer BML may entirely overlap a channel area C1 of the driving semiconductor layer A1 of the driving transistor T1.

A buffer layer 111 may be disposed on the lower metal layer BML. The buffer layer 111 may be an inorganic insulating layer including an inorganic insulating material such as silicon nitride and/or silicon oxide and may have a single or multi-layer structure including the materials described above.

Transistors including a silicon semiconductor layer may be disposed on the buffer layer 111. In this regard, FIG. 6 illustrates the driving semiconductor layer A1 of the driving transistor T1 corresponding to a portion of a first silicon semiconductor pattern 1110. The driving semiconductor layer A1 may include the channel area C1 and impurity areas arranged on both sides of the channel area C1 and doped with impurities. In this regard, FIG. 4 illustrates a first area B1, which is one of the impurity areas arranged on one side or a side of the channel area C1.

The first gate insulating layer 112 may be disposed on the first silicon semiconductor pattern 1110, such as the driving semiconductor layer A1. The first gate insulating layer 112 may be an inorganic insulating layer including an inorganic insulating material such as silicon oxide, silicon nitride and/or silicon oxynitride and may have a single or multi-layer structure including the materials described above.

A first conductive pattern 1210 may be disposed on the first gate insulating layer 112. The first conductive pattern 1210 may include a driving gate electrode G1 and/or a lower electrode CE1 of the first capacitor Cst. In the first conductive pattern 1210, the driving gate electrode G1 may function as the lower electrode CE1 or the lower electrode CE1 may function as the driving gate electrode G1. In other words, the driving gate electrode G1 may be integral with the lower electrode CE1.

The first conductive pattern 1210, such as the driving gate electrode G1 and/or the lower electrode CE1 of the first capacitor Cst, may include Al, Pt, Pd, Ag, Mg, Au, Ni, Nd, Ir, Cr, Li, Ca, Mo, Ti, W, and/or Cu and may be formed of a single layer or multiple layers including the above materials. In an embodiment, the driving gate electrode G1 and/or the lower electrode CE1 of the first capacitor Cst may include a single layer of Mo.

A second gate insulating layer 113 may be disposed on the driving gate electrode G1 and/or the lower electrode CE1 of the first capacitor Cst. The second gate insulating layer 113 may be an inorganic insulating layer including an inorganic insulating material such as silicon oxide, silicon nitride and/or silicon oxynitride and may have a single or multi-layer structure including the materials described above.

Another conductive pattern (hereinafter referred to as a third conductive pattern 1310) may be disposed on the second gate insulating layer 113. The third conductive pattern 1310 may include an upper electrode CE2 of the first capacitor Cst. The third conductive pattern 1310, such as the upper electrode CE2 of the first capacitor Cst, may include Al, Pt, Pd, Ag, Mg, Au, Ni, Nd, Ir, Cr, Li, Ca, Mo, Ti, W, and/or Cu and may be formed of a single layer or multiple layers including the above materials. In an embodiment, the upper electrode CE2 may include a same material as the lower electrode CE1 and/or the lower metal layer BML.

The upper electrode CE2 may overlap the driving gate electrode G1 and/or the lower electrode CE1. The upper electrode CE2 may include an opening 1310OP such that a first connection electrode 1630 electrically connecting the driving gate electrode G1 of the driving transistor T1 to the compensation semiconductor layer A3 of the compensation transistor T3 contacts the driving gate electrode G1. The opening 1310OP may overlap a portion of the driving gate electrode G1.

A first interlayer insulating layer 114 may be disposed on the upper electrode CE2. The first interlayer insulating layer 114 may be an inorganic insulating layer including an inorganic insulating material such as silicon oxide, silicon nitride, and/or silicon oxynitride and may have a single or multi-layer structure including the materials described above.

An oxide semiconductor pattern 1410 may be disposed on the first interlayer insulating layer 114. In this regard, FIG. 6 illustrates the compensation semiconductor layer A3 of the compensation transistor T3 corresponding to a portion of the oxide semiconductor pattern 1410. The oxide semiconductor pattern 1410 may include InSnZnO (ITZO), InGaZnO (IGZO), and the like.

The compensation semiconductor layer A3 may include a channel area C3 and conductive areas arranged on both sides of the channel area C1. In this regard, FIG. 6 illustrates an area B3 of the conductive areas arranged on a side of the channel area C3. The compensation semiconductor layer A3 and the driving semiconductor layer A1 may be arranged on different layers. For example, the driving semiconductor layer A1 may be disposed on the buffer layer 111 and the compensation semiconductor layer A3 may be disposed on the first interlayer insulating layer 114. In other words, a vertical distance from the substrate 100 to the compensation semiconductor layer A3 may be greater than a vertical distance from the substrate 100 to the driving semiconductor layer A1.

The third gate electrode G3 may be disposed below and/or above the compensation semiconductor layer A3. In an embodiment, FIG. 6 illustrates that the third gate electrode G3 may include a lower compensation gate electrode G3a disposed below the compensation semiconductor layer A3 and an upper compensation gate electrode G3b disposed over the compensation semiconductor layer A3. In an embodiment, one of the lower compensation gate electrode G3a and the upper compensation gate electrode G3b may be omitted.

The lower compensation gate electrode G3a may include a same material as the upper electrode CE2 and may be arranged on the same layer (for example, the second gate insulating layer 113) as the upper electrode CE2. The upper compensation gate electrode G3b may be disposed over the compensation semiconductor layer A3 with a third gate insulating layer 115 therebetween. The upper compensation gate electrode G3b may include Al, Pt, Pd, Ag, Mg, Au, Ni, Nd, Ir, Cr, Li, Ca, Mo, Ti, W, and/or Cu and may be formed of a single layer or multiple layers including the above materials.

FIG. 6 illustrates that the third gate insulating layer 115 may be arranged between the upper compensation gate electrode G3b and the compensation semiconductor layer A3, but the invention is not limited thereto. In an embodiment, the third gate insulating layer 115 may entirely cover another insulating layer in the same manner as the first gate insulating layer 112 entirely covers the substrate 100, for example. The third gate insulating layer 115 may be an inorganic insulating layer including an inorganic insulating material such as silicon oxide, silicon nitride, and/or silicon oxynitride and may have a single or multi-layer structure including the above materials.

The second interlayer insulating layer 116 may be disposed on the upper compensation gate electrode G3b. The second interlayer insulating layer 116 may be an inorganic insulating layer including an inorganic insulating material such as silicon oxide, silicon nitride, and/or silicon oxynitride and may have a single or multi-layer structure including the materials described above.

The first connection electrode 1630 and the compensation scan line GCL may be disposed on the second interlayer insulating layer 116. The first connection electrode 1630 and the compensation scan line GCL may include Al, Pt, Pd, Ag, Mg, Au, Ni, Nd, Ir, Cr, Li, Ca, Mo, Ti, W, and/or Cu and may be formed of a single layer or multiple layers including the above materials. In an embodiment, the first connection electrode 1630 and the compensation scan line GCL may have a three-layer structure in which an Al layer, a Ti layer, and an Al layer are stacked. The compensation scan line GCL may be electrically connected to the upper compensation gate electrode G3b through a contact hole penetrating the second interlayer insulating layer 116.

The first organic insulating layer 121 may be formed on the first connection electrode 1630 and the compensation scan line GCL. The first organic insulating layer 121 may include an organic material such as acryl, benzocyclobutene (BCB), polyimide, or hexamethyldisiloxane (HMDSO).

The driving voltage line PL may be disposed on the first organic insulating layer 121. The driving voltage line PL may overlap the driving transistor T1 and the first capacitor Cst. In an embodiment, the driving voltage line PL may overlap the compensation transistor T3. The driving voltage line PL may include Al, Pt, Pd, Ag, Mg, Au, Ni, Nd, Ir, Cr, Li, Ca, Mo, Ti, W, and/or Cu and may be formed of a single layer or multiple layers including the above materials. In an embodiment, the driving voltage line PL may have a three-layer structure in which an Al layer, a Ti layer, and an Al layer are stacked.

The second organic insulating layer 123 may be disposed on the driving voltage line PL. The second organic insulating layer 123 may include an organic material such as BCB, polyimide, or HMDSO.

The light-emitting diode LED may be formed on the second organic insulating layer 123. The light-emitting diode LED may include a pixel electrode 210, an intermediate layer 220, and a counter electrode 230 on the second organic insulating layer 123.

An edge of the pixel electrode 210 may be covered by a bank layer 130 and an inner portion of the pixel electrode 210 may overlap the intermediate layer 220 through an opening 130OP of the bank layer 130. Compared to the pixel electrode 210 being formed in each light-emitting diode LED, the counter electrode 230 may be formed correspondingly to the light-emitting diodes LED. In other words, the light-emitting diodes LED may share the counter electrode 230, and a stack structure of the pixel electrode 210, the intermediate layer 220, and the counter electrode 230 may correspond to the light-emitting diode LED.

The intermediate layer 220 may include an emission layer. In an embodiment, the intermediate layer 220 may further include an emission layer and a functional layer. The functional layer may include a hole transport layer (HTL), a hole injection layer (HIL), an electron transport layer (ETL), and/or an electron injection layer (EIL). In an embodiment, the intermediate layer 220 may include a first stack including the emission layer and the functional layer, a second stack including the emission layer and the functional layer, and a charge generation layer between the first stack and the second stack. The charge generation layer may include a negative charge generation layer and a positive charge generation layer. The luminous efficiency of the light-emitting diode LED, which is a tandem light-emitting device including emission layers, may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

The encapsulation layer 300 may be disposed on the light-emitting diode LED. The encapsulation layer 300 may include at least one inorganic encapsulation layer and organic encapsulation layer each. As an embodiment, FIG. 6 shows the encapsulation layer 300 including a first inorganic encapsulation layer 310, an organic encapsulation layer 320, and a second inorganic encapsulation layer 330. The first inorganic encapsulation layer 310 and the second inorganic encapsulation layer 330 may include silicon oxide, silicon nitride, and/or silicon oxynitride, and the organic encapsulation layer 320 may include an organic insulating material.

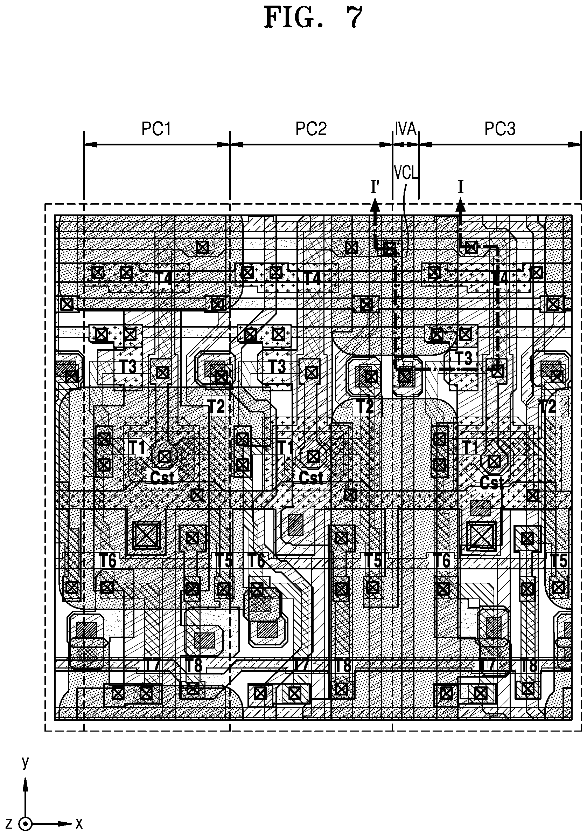

FIG. 7 is a schematic plan view illustrating first to third pixel circuits of the display device according to an embodiment. The first pixel circuit PC1, the second pixel circuit PC2, and the third pixel circuit PC3 shown in FIG. 7 may be arranged along the ith row.

Referring to FIG. 7, the first pixel circuit PC1, the second pixel circuit PC2, and the third pixel circuit PC3 may each include transistors and capacitors. In an embodiment, FIG. 7 illustrates that each of the first pixel circuit PC1, the second pixel circuit PC2, and the third pixel circuit PC3 may include the eight transistors T1, T2, T3, T4, T5, T6, T7, and T8 and the first capacitor Cst described with reference to FIG. 3.

The driving transistor T1 may overlap the first capacitor Cst. The switching transistors (for example, T2, T3, T4, T5, T6, T7, and T8) may be arranged over and/or below the first transistor T1 and/or the first capacitor Cst in a plan view. In an embodiment, FIG. 7 illustrates the data write transistor T2, the compensation transistor T3, and the first initialization transistor T4 arranged over the driving transistor T1 and/or the first capacitor Cst (for example, in the +y direction) in a plan view. The operation control transistor T5, the emission control transistor T6, the second initialization transistor T7, and the bias transistor T8 may be arranged below the driving transistor T1 and/or the first capacitor Cst (for example, in the -y direction) in a plan view.

The first pixel circuit PC1, the second pixel circuit PC2, and the third pixel circuit PC3 may be arranged along the first direction, and a first distance between the second pixel circuit PC2 and the third pixel circuit PC3 may be greater than a second distance between the first pixel circuit PC1 and the second pixel circuit PC2. A vertical voltage line VCL may be arranged in a space that is the first distance between the second pixel circuit PC2 and the third pixel circuit PC3 (hereinafter referred to as a gap space IVA). The vertical voltage line VCL shown in FIG. 6 may be the first initialization vertical voltage line VVIL, the common voltage line VSL, the second-1 initialization vertical voltage line VVAL1, and/or the second-2 initialization vertical voltage line VVAL2 described with reference to FIG. 5.

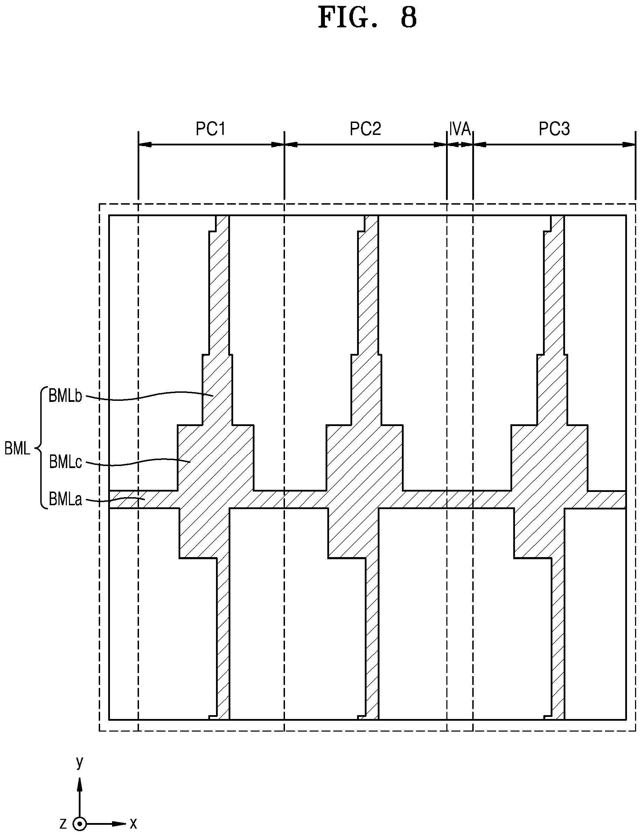

FIGS. 8 to 18 are schematic plan views showing a process of forming the first to third pixel circuits shown in FIG. 7.

Referring to FIG. 8, the lower metal layer BML may be disposed on the substrate. The lower metal layer BML may include a main portion BMLc corresponding to each of the first to third pixel circuits PC1, PC2 and PC3. The lower metal layer BML may include a first branch portion BMLa connecting main portions BMLc to each other along the first direction (for example, the ±x direction) and a second branch portion BMLb connecting the main portions BMLc to each other along the second direction (for example, the ±y direction), the main portions BMLc being respectively arranged in the pixel circuits arranged in different rows from each other. The main portion BMLc, the first branch portion BMLa, and the second branch portion BMLb may be integral with each other.

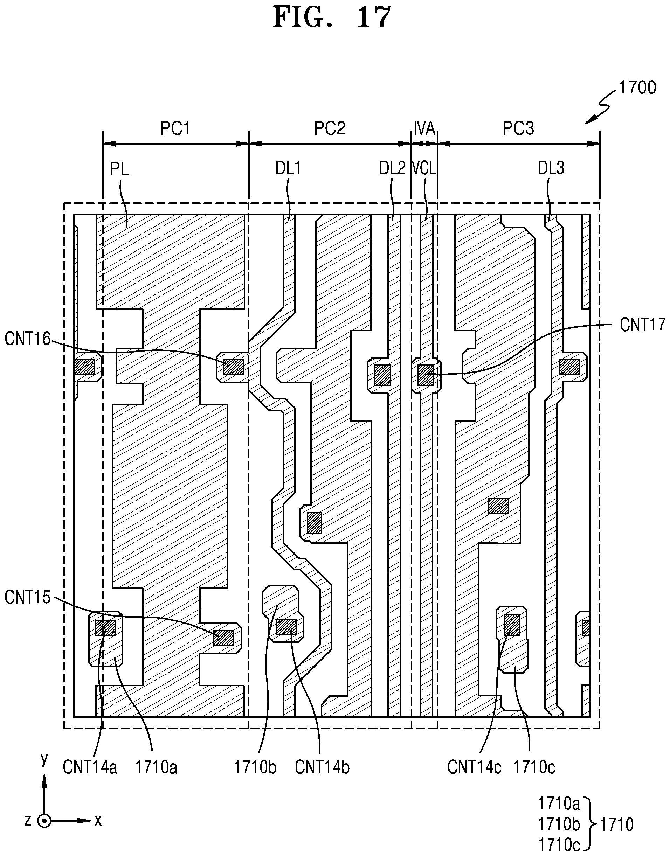

The lower metal layer BML may be electrically connected to the driving voltage line PL (FIG. 3) and may have the same voltage level as the driving voltage line PL (FIG. 17).

The lower metal layer BML may include at least one material selected from Al, Pt, Pd, Ag, Mg, Au, Ni, Nd, Ir, Cr, Li, Ca, Mo, Ti, W, and Cu. In an embodiment, the lower metal layer BML may have a single layer including Mo, a two-layer structure in which a Mo layer and a Ti layer are stacked, and a three-layer structure in which a Ti layer, an Al layer, and a Ti layer are stacked.

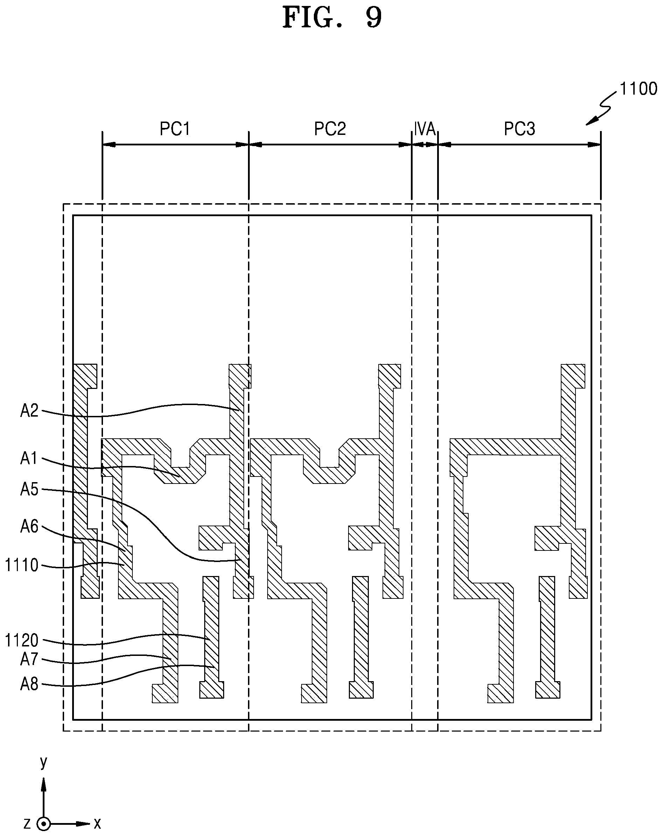

Referring to FIGS. 6 and 9, the buffer layer 111 (FIG. 4) may be disposed on the lower metal layer BML and the silicon semiconductor layer 1100 may be disposed on the buffer layer 111 (FIG. 4). The silicon semiconductor layer 1100 may include the first silicon semiconductor pattern 1110 and a second silicon semiconductor pattern 1120.

The first silicon semiconductor pattern 1110 and the second silicon semiconductor pattern 1120 may be arranged correspondingly to each of the first to third pixel circuits PC1, PC2, and PC3. The first silicon semiconductor pattern 1110 arranged in each of the first to third pixel circuits PC1, PC2, and PC3 may be separated and apart from each other. The first silicon semiconductor pattern 1110 and the second silicon semiconductor pattern 1120 corresponding to the same pixel circuit may be apart from each other, but the invention is not limited thereto. In an embodiment, the first silicon semiconductor pattern 1110 and the second silicon semiconductor pattern 1120 corresponding to the same pixel circuit may be integral with each other.

The first silicon semiconductor pattern 1110 may include a driving semiconductor layer A1 of the driving transistor T1 (FIG. 7), a semiconductor layer of the data write transistor T2 (FIG. 7) (hereinafter referred to as a data write semiconductor layer A2), a semiconductor layer of the operation control transistor T5 (FIG. 7) (hereinafter referred to as an operation control semiconductor layer A5), a semiconductor layer of the emission control transistor T6 (FIG. 7) (hereinafter referred to as an emission control semiconductor layer A6), and a semiconductor layer of the second initialization transistor T7 (FIG. 7) (hereinafter referred to as a second initialization semiconductor layer A7). The second silicon semiconductor pattern 1120 may include a semiconductor layer of the bias transistor T8 (FIG. 7) (hereinafter referred to as a bias semiconductor layer A8).

The first silicon semiconductor pattern 1110 and the second silicon semiconductor pattern 1120 may include an amorphous silicon or polysilicon. For example, the first silicon semiconductor pattern 1110 and the second silicon semiconductor pattern 1120 may include a polysilicon crystallized at a low temperature.

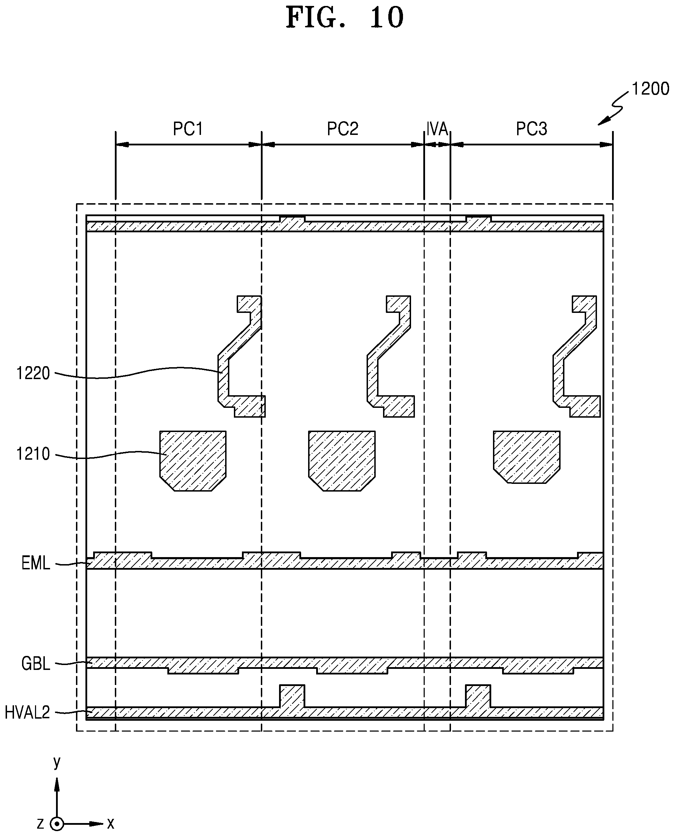

Referring to FIGS. 6 and 10, the first gate insulating layer 112 (FIG. 6) may be disposed on the silicon semiconductor layer 1100 (FIG. 9) and the first conductive layer 1200 may be disposed on the first gate insulating layer 112 (FIG. 6). The first conductive layer 1200 may include the first conductive pattern 1210, a second conductive pattern 1220, the emission control line EML, the second initialization control line GBL, and the second-2 initialization horizontal voltage line HVAL2.

The first conductive pattern 1210, the second conductive pattern 1220, the emission control line EML, the second initialization control line GBL, and the second-2 initialization horizontal voltage line HVAL2 may include a same material. The first conductive pattern 1210, the second conductive pattern 1220, the emission control line EML, the second initialization control line GBL, and the second-2 initialization horizontal voltage line HVAL2 may include Al, Pt, Pd, Ag, Mg, Au, Ni, Nd, Ir, Cr, Li, Ca, Mo, Ti, W, and/or Cu, and may be formed of a single layer or multiple layers including the above materials.

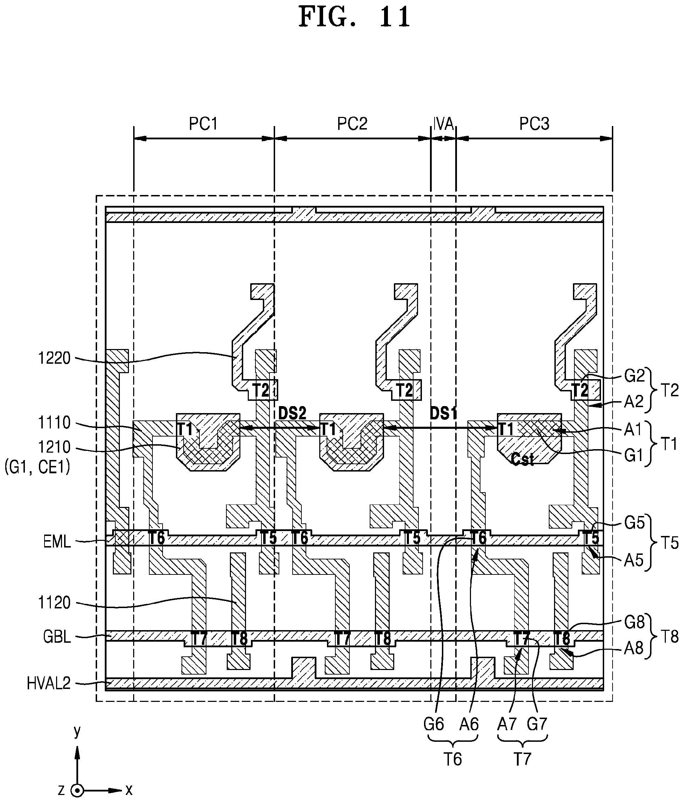

Referring to FIG. 11, the first conductive pattern 1210, the second conductive pattern 1220, the emission control line EML, and the second initialization control line GBL each may include the gate electrode overlapping the first silicon semiconductor pattern 1110 and/or the second silicon semiconductor pattern 1120.

The first conductive pattern 1210 may be arranged in each of the first to third pixel circuits PC1, PC2, and CP3 and may have an isolated shape. The first conductive pattern 1210 may include the driving gate electrode G1 of the driving transistor T1. The driving semiconductor layer A1 may include a channel area overlapping the first conductive pattern 1210, which is the driving gate electrode G1, and a source area and a drain area respectively arranged on both sides of the channel area. Referring to FIGS. 8 and 11, the channel area of the driving semiconductor layer A1 may overlap a portion of the lower metal layer BML (for example, the main portion BMLc). The channel area of the driving semiconductor layer A1 of each of the first and second pixel circuits PC1 and PC2 may have a shape that is bent several times (for example, an omega shape). Considering the efficiency of the third light-emitting diode electrically connected to the third pixel circuit PC3, the shape of the channel area of the driving semiconductor layer A1 of the third pixel circuit PC3 may have a straight linear shape.

A distance between the second pixel circuit PC2 and the third pixel circuit PC3 being greater than a distance between the second pixel circuit PC2 and the first pixel circuit PC1 may be confirmed from a distance between the driving transistors T1 of each of the second pixel circuit PC2 and the third pixel circuit PC3 being greater than a distance between the driving transistors T1 of each of the second pixel circuit PC2 and the first pixel circuit PC1. For example, the above distance may be confirmed from a first distance DS1, measured in the first direction (for example, the ±x direction), between the channel area of the driving transistor T1 of the second pixel circuit PC2 and the channel area of the driving transistor T1 of the third pixel circuit being greater than a second distance DS2 between the channel area of the driving transistor T1 of the second pixel circuit PC2 and the channel area of the driving transistor T1 of the first pixel circuit PC1. In other words, the above distance may be confirmed from the first distance DS1, measured in the first direction (for example, the ±x direction), between the driving gate electrode G1 of the driving transistor T1 of the second pixel circuit PC2 and the driving gate electrode G1 of the driving transistor T1 of the third pixel circuit PC3 being greater than the second distance DS2 between the driving gate electrode G1 of the driving transistor T1 of the second pixel circuit PC2 and the driving gate electrode G1 of the driving transistor T1 of the first pixel circuit PC1.

In an embodiment, the first conductive pattern 1210 may include the lower electrode CE1 of the first capacitor Cst (FIG. 3). The first conductive pattern 1210 may be the driving gate electrode G1 and/or the lower electrode CE1 of the first capacitor Cst (FIG. 3).

The second conductive pattern 1220 may be arranged in each of the first to third pixel circuits PC1, PC2, and CP3 and may have an isolated shape. The second conductive pattern 1220 may include a second gate electrode G2 of the data write transistor T2. The data write semiconductor layer A2 may include a channel area overlapping the second gate electrode G2 of the data write transistor T2, and a source area and a drain area respectively arranged on both sides of the channel area described above.

The emission control line EML may extend across the first to third pixel circuits PC1, PC2, and PC3 in the first direction (for example, the ±x direction). The emission control line EML may include the operation control gate electrode G5 of the operation control transistor T5 and the emission control gate electrode G6 of the emission control transistor T6. The operation control semiconductor layer A2 may include a channel area overlapping the operation control gate electrode G5 and a source area and a drain area respectively arranged on both sides of the channel area described above. The emission control semiconductor layer A6 may include a channel area overlapping the emission control gate electrode G6 and a source area and a drain area respectively arranged on both sides of the channel area described above.

The second initialization control line GBL may extend across the first to third pixel circuits PC1, PC2, and PC3 in the first direction (for example, the ±x direction). The second initialization control line GBL may include a second initialization gate electrode G7 of the second initialization transistor T7 and a bias gate electrode G8 of the bias transistor T8. The second initialization semiconductor layer A7 may include a channel area overlapping the second initialization gate electrode G7 and a source area and a drain area respectively arranged on both sides of the channel area described above. The bias semiconductor layer A2 may include a channel area overlapping the bias gate electrode G8 and a source area and a drain area respectively arranged on both sides of the channel area described above.

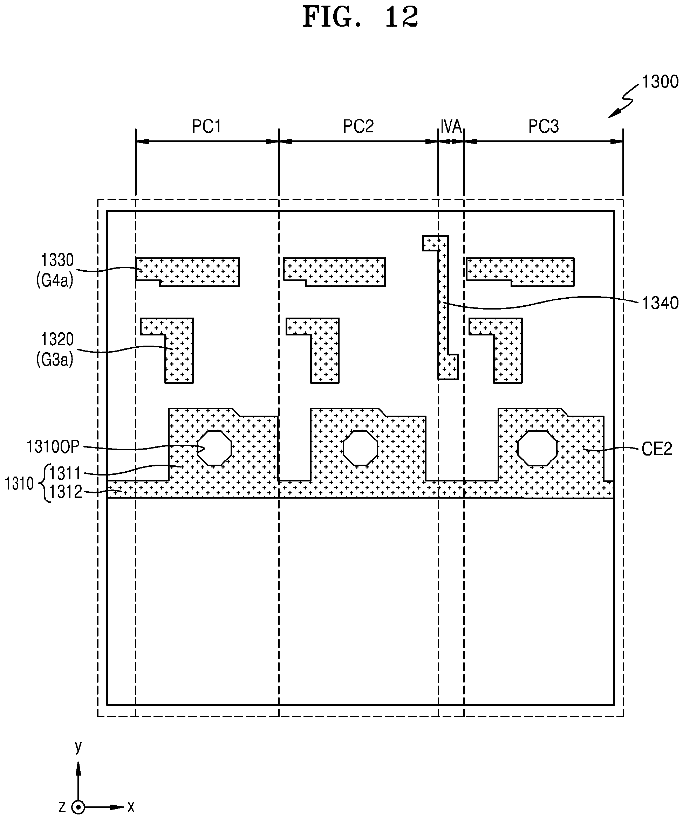

Referring to FIG. 6, the second gate insulating layer 113 (FIG. 4) may be disposed on the first conductive layer 1200 described in FIG. 11. Subsequently, a second conductive layer 1300 may be disposed on the second gate insulating layer 113 (FIG. 4) described in FIG. 12. The second conductive layer 1300 may include the third conductive pattern 1310, a fourth conductive pattern 1320, a fifth conductive pattern 1330, and a sub-bridge pattern 1340.

The third conductive pattern 1310, the fourth conductive pattern 1320, and the fifth conductive pattern 1330 may include a same material. The third conductive pattern 1310, the fourth conductive pattern 1320, the fifth conductive pattern 1330, and the sub-bridge pattern 1340 may include Al, Pt, Pd, Ag, Mg, Au, Ni, Nd, Ir, Cr, Li, Ca, Mo, Ti, W, and/or Cu and may be formed of a single layer or multiple layers including the above materials.

Referring to FIGS. 11 and 12, the third conductive pattern 1310 may overlap the first conductive pattern 1210. The third conductive pattern 1310 is a horizontal driving voltage line having a voltage level of the driving voltage and may extend in the first direction (for example, the ±x direction) across the first to third pixel circuits PC1, PC2, and CP3.

In an embodiment, the third conductive pattern 1310 may include first portions 1311 overlapping the first conductive patterns 1210 arranged in each of the first to third pixel circuits PC1, PC2, and PC3 and a second portion 1312 extending in the first direction (for example, the x direction) to connect the first portions 1311 arranged in each of the first to third pixel circuits PC1, PC2, and PC3.

The first conductive pattern 1210 arranged in each of the first to third pixel circuits PC1, PC2, and PC3 may correspond to the lower electrode CE1 of the first capacitor Cst. The first portion 1311 of the third conductive pattern 1310 arranged in each of the first to third pixel circuits PC1, PC2, and PC3 may correspond to the upper electrode CE2 of the first capacitor Cst.

Referring to FIGS. 8 and 12, the third conductive pattern 1310 may overlap the lower metal layer BML. The first portion 1311 of the third conductive pattern 1310 may overlap the main portion BMLc of the lower metal layer BML and the second portion 1312 of the third conductive pattern 1310 may overlap the first branch portion BMLa of the lower metal layer BML.

The third conductive pattern 1310 and the lower metal layer BML having the same voltage level may overlap each other to prevent undesired coupling between the driving transistor T1 and components (wirings or electrodes) surrounding the driving transistor T1, and the transistors, the voltage lines, and the signal lines of the first to third pixel circuits PC1, PC2, and PC3 may be effectively arranged in a limited space to improve space efficiency (for example, improve density). The third conductive pattern 1310 may have the opening 1310OP of a closed shape.

Each of the fourth conductive pattern 1320 and the fifth conductive pattern 1330 may be disposed in each of the first to third pixel circuits PC1, PC2, and PC3. Each of the fourth conductive pattern 1320 and the fifth conductive pattern 1330 may have an isolated shape.

The fourth conductive pattern 1320 may correspond to the lower compensation gate electrode G3a of the compensation transistor T3 described below, and the fifth conductive pattern 1330 may correspond to a lower first initialization gate electrode G4a of the first initialization transistor T4.

The sub-bridge pattern 1340 may be arranged in a gap space IVA between the second pixel circuit PC2 and the third pixel circuit PC3. The sub-bridge pattern 1340 may electrically connect the vertical voltage line VCL (FIG. 7) to the horizontal voltage line described below. However, the sub-bridge pattern 1340 may not be disposed in all the gap spaces IVA arranged in the display area DA (FIG. 1). In case that the vertical voltage line VCL (FIG. 7) is the first initialization vertical voltage line VVIL (FIG. 5), the sub-bridge pattern 1340 may be arranged in the gap space IVA as shown in FIG. 12. If the vertical voltage line VCL (FIG. 7) is the common voltage line VSL (FIG. 5) or the initialization vertical voltage line VVAL, the sub-bridge pattern 1340 may not be arranged in the gap space IVA. In other words, according to the layer in which the horizontal voltage line to which the corresponding vertical voltage line VCL (FIG. 7) is connected is arranged, whether the sub-bridge pattern 1340 is arranged in the gap space IVA may be determined.

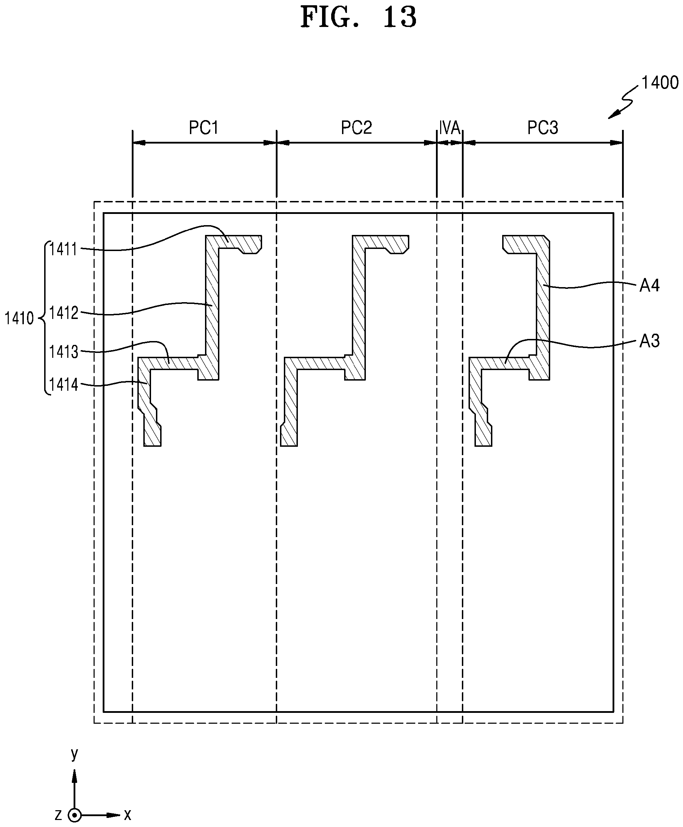

Referring to FIGS. 6 and 13, the first interlayer insulating layer 114 (FIG. 6) may be disposed on the second conductive layer 1300 described with reference to FIG. 12. Subsequently, an oxide semiconductor pattern 1410 may be disposed on the first interlayer insulating layer 114 (FIG. 6). The oxide semiconductor layer 1400 may include the oxide semiconductor pattern 1410.

As shown in FIG. 13, the oxide semiconductor pattern 1410 may have a bent shape. For example, the oxide semiconductor pattern 1410 may include a portion corresponding to the compensation semiconductor layer A3 overlapping the fourth conductive pattern 1320 and extending in the first direction (for example, the ±x direction) and a portion corresponding to a first initialization semiconductor layer A4 overlapping the fifth conductive pattern 1330 and extending in the second direction (for example, the ±y direction).

For example, the oxide semiconductor pattern 1410 may include the first portion 1411, a second portion 1412 (or a first extension area), a third portion 1413, and a fourth portion 1414 (or a second extension area). The first portion 1411, the second portion 1412, the third portion 1413, and the fourth portion 1414 may be integral with each other.

The oxide semiconductor pattern 1410 may include an ITZO semiconductor layer, an IGZO semiconductor layer, and the like. Since the oxide semiconductor has a wide band gap (about 3.1 eV), a high carrier mobility, and a low leakage current, the voltage drop is not significant regardless of a long driving time, and thus, a luminance change according to the voltage drop may not be significant even during low-frequency driving.

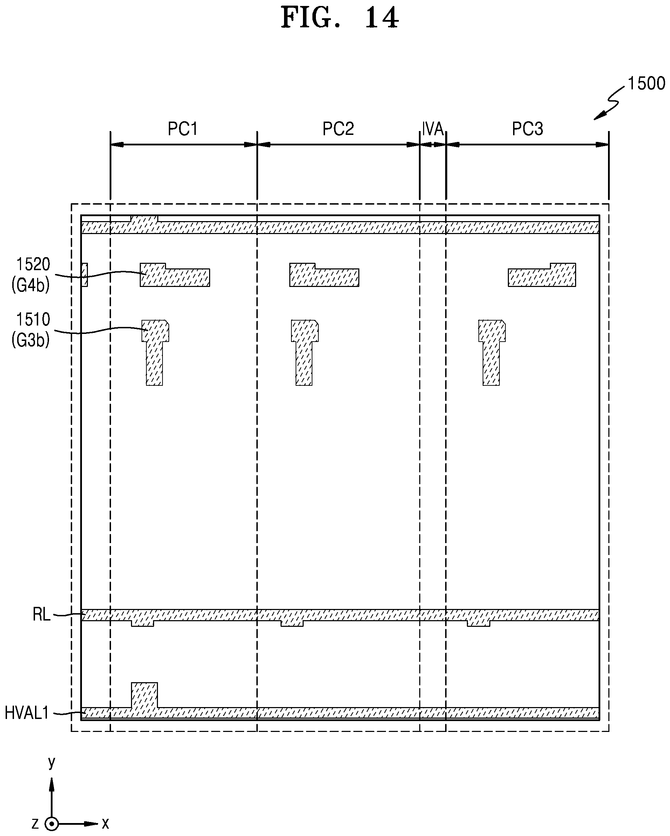

Referring to FIG. 14, a third conductive layer 1500 may be disposed on the structure described with reference to FIG. 13. A sixth conductive pattern 1510, a seventh conductive pattern 1520, the repair line RL, and the second-2 initialization horizontal voltage line HVAL 1 may be arranged in the third conductive layer 1500.

The sixth conductive pattern 1510, the seventh conductive pattern 1520, the repair line RL, and the second-1 initialization horizontal voltage line HVAL1 may include a same material. The sixth conductive pattern 1510, the seventh conductive pattern 1520, the repair line RL, and the second-1 initialization horizontal voltage line HVAL1 may include Al, Pt, Pd, Ag, Mg, Au, Ni, Nd, Ir, Cr, Li, Ca, Mo, Ti, W, and/or Cu and may be formed of a single layer or multiple layers including the above materials. In an embodiment, the sixth conductive pattern 1510, the seventh conductive pattern 1520, the repair line RL, and the second-1 initialization horizontal voltage line HVAL1 may have a three-layer structure in which an Al layer, a Ti layer, and an Al layer are stacked.

Each of the sixth conductive pattern 1510 and the seventh conductive pattern 1520 may be disposed in each of the first to third pixel circuits PC1, PC2, and PC3. Each of the sixth conductive pattern 1510 and the seventh conductive pattern 1520 may have an isolated shape.

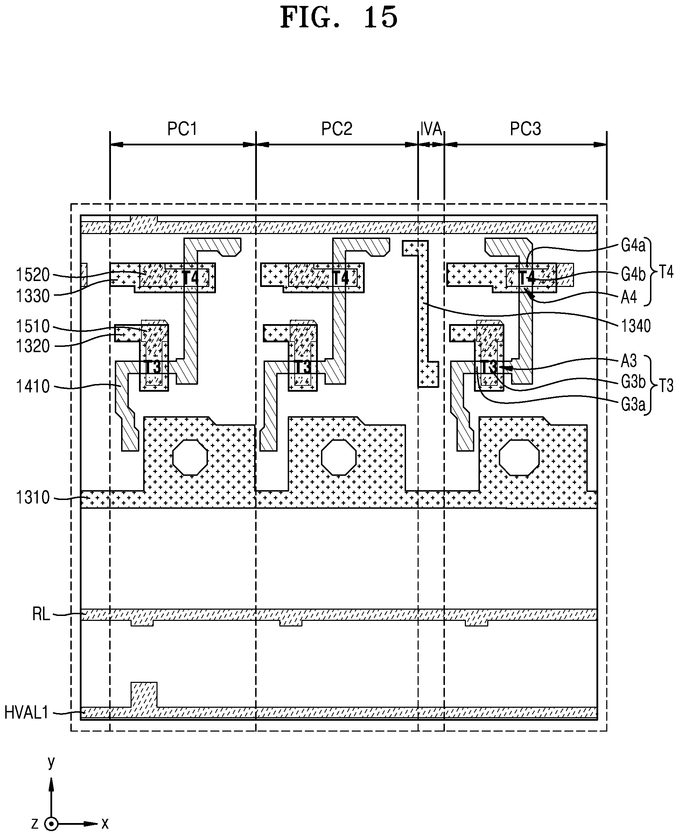

Referring to FIG. 15, the sixth conductive pattern 1510 and the seventh conductive pattern 1520 each may overlap the oxide semiconductor pattern 1410 and include a gate electrode. The sixth conductive pattern 1510 may include a portion of the oxide semiconductor pattern 1410, such as the upper compensation gate electrode G3b overlapping the compensation semiconductor layer A3. The seventh conductive pattern 1520 may include a portion of the oxide semiconductor pattern 1410, such as an upper initialization gate electrode G4b overlapping the first initialization semiconductor layer A4.

The compensation semiconductor layer A3 arranged in each of the first to third pixel circuits PC1, PC2, and PC3 may include a channel area overlapping the fourth conductive pattern 1320 disposed below the compensation semiconductor layer A3 and the sixth conductive pattern 1510 disposed over the compensation semiconductor layer A3 and a source area and a drain area respectively arranged on both sides of the channel area. The first initialization semiconductor layer A4 arranged in each of the first to third pixel circuits PC1, PC2, and PC3 may include a channel area overlapping the fifth conductive pattern 1330 disposed below the first initialization semiconductor layer A4 and the seventh conductive pattern 1520 disposed over the first initialization semiconductor layer A4 and a source area and a drain area respectively arranged on both sides of the channel area.

The fourth conductive pattern 1320 and the sixth conductive pattern 1510 may correspond to the lower compensation gate electrode G3a and the upper compensation gate electrode G3b of the compensation transistor T3, respectively. The fifth conductive pattern 1330 and the seventh conductive pattern 1520 may correspond to the lower first initialization gate electrode G4a and the upper first initialization gate electrode G4b of the first initialization transistor T4, respectively.

FIG. 15 illustrates that the compensation transistor T3 may include a double gate electrode including the lower compensation gate electrode G3a and the upper compensation gate electrode G3b and that the first initialization transistor T4 may include a double gate electrode including the lower first initialization gate electrode G4a and the upper first initialization gate electrode G4b, but the invention is not limited thereto. In an embodiment, the compensation transistor T3 may include one of the lower compensation gate electrode G3a and the upper compensation gate electrode G3b, and the first initialization transistor T4 may include one of the lower first initialization gate electrode G4a and the upper first initialization gate electrode G4b.

The second-1 initialization horizontal voltage line HVAL1 may be arranged on the same layer as the sixth conductive pattern 1510, which is the gate electrode (for example, the upper compensation gate electrode G3b) of the compensation transistor T3, the seventh conductive pattern 1520, which is the gate electrode (for example, the upper first initialization gate electrode G4b) of the first initialization transistor T4, and the repair line RL. For example, each of the second-1 initialization horizontal voltage line HVAL1, the sixth conductive pattern 1510, the seventh conductive pattern 1520, and the repair line RL may be disposed on the third gate insulating layer 115 (FIG. 6).

In an embodiment, as described above with reference to FIG. 6, the third gate insulating layers 115 (FIG. 6) disposed below the sixth conductive pattern 1510, the seventh conductive pattern 1520, the repair line RL, and the second-1 initialization horizontal voltage line HVAL1 may be separated from each other, but the invention is not limited thereto. In an embodiment, the third gate insulating layers 115 (FIG. 6) disposed below each of the sixth conductive pattern 1510, the seventh conductive pattern 1520, the repair line RL, and the second-1 initialization horizontal voltage line HVAL1 may be integral with each other.

The second-1 initialization horizontal voltage line HVAL1 and the second-2 initialization horizontal voltage line HVAL2 (FIG. 11) may overlap each other. The second-2 initialization horizontal voltage line HVAL2 (FIG. 11) and the second-1 initialization horizontal voltage line HVAL1 may have a voltage level of a constant voltage. For example, the second-2 initialization horizontal voltage line HVAL2 (FIG. 11) and the second-1 initialization horizontal voltage line HVAL1 may have the same or similar voltage levels. Since the second-2 initialization horizontal voltage line HVAL2 (FIG. 11) and the second-1 initialization horizontal voltage line HVAL1 having the same or similar voltage levels overlap each other, a limited space in which the electrode of the transistors, the voltage lines, and/or the signal lines of the first to third pixel circuits PC1, PC2, and PC3 may be efficiently used (for example, density may be improved) while minimizing the occurrence of parasitic capacitance.

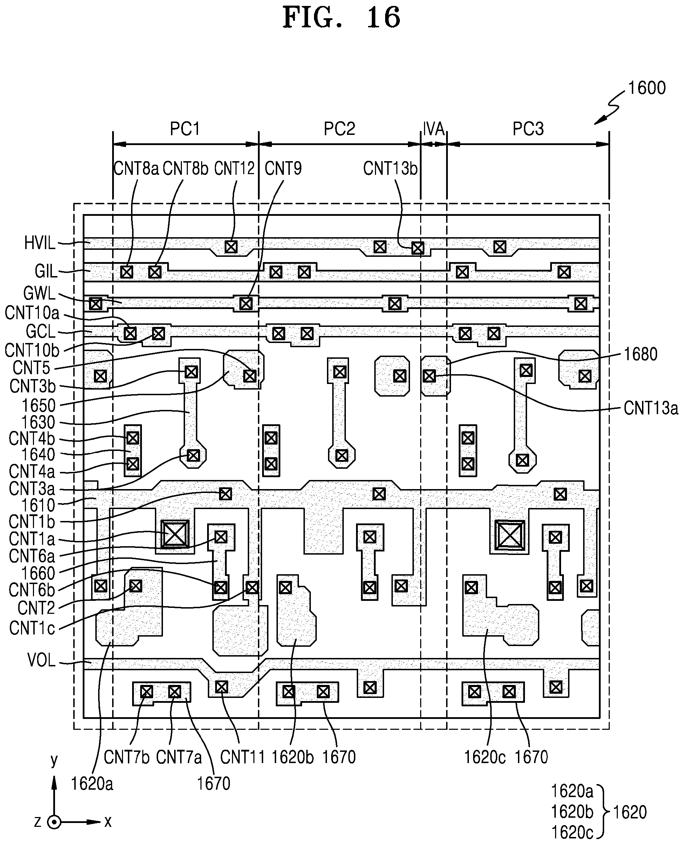

Referring to FIGS. 6 and 16, the second interlayer insulating layer 116 (FIG. 6) may be disposed on the third conductive layer 1500 described with reference to FIG. 15. Subsequently, a fourth conductive layer 1600 may be disposed on the second interlayer insulating layer 116. The fourth conductive layer 1600 may include a voltage transfer wiring 1610, a first pixel connection electrode 1620, a first connection electrode 1630, a second connection electrode 1640, a third connection electrode 1650, a fourth connection electrode 1660, a fifth connection electrode 1670, a bridge pattern 1680, the first initialization horizontal voltage line HVIL, the first initialization control line GIL, the scan line GWL, the compensation scan line GCL, and the bias voltage line VOL.

The voltage transfer wiring 1610, the first pixel connection electrode 1620, the first connection electrode 1630, the second connection electrode 1640, the third connection electrode 1650, the fourth connection electrode 1660, the fifth connection electrode 1670, the bridge pattern 1680, the first initialization horizontal voltage line HVIL, the first initialization control line GIL, the scan line GWL, the compensation scan line GCL, and the bias voltage line VOL may include a same material. The voltage transfer wiring 1610, the first pixel connection electrode 1620, the first connection electrode 1630, the second connection electrode 1640, the third connection electrode 1650, the fourth connection electrode 1660, the fifth connection electrode 1670, the bridge pattern 1680, the first initialization horizontal voltage line HVIL, the first initialization control line GIL, the scan line GWL, the compensation scan line GCL, and the bias voltage line VOL may include at least one material selected from Al, Pt, Pd, Ag, Mg, Au, Ni, Nd, Ir, Cr, Li, Ca, Mo, Ti, W, and Cu.

The voltage transfer wiring 1610 may extend in the first direction (for example, the ±x direction). The voltage transfer wiring 1610 may cross intersect each of the first pixel circuit PC1, the second pixel circuit PC2, and the third pixel circuit PC3. The voltage transfer wiring 1610 may overlap the repair line RL (FIG. 14).

In an embodiment, the voltage transfer wiring 1610 may include a voltage level of the driving voltage ELVDD (FIG. 3). In an embodiment, the voltage transfer wiring 1610 may be electrically connected to the driving voltage line PL (FIG. 17) to have a voltage level of the driving voltage ELVDD (FIG. 3).

The voltage transfer wiring 1610 may be electrically connected to the lower metal layer BML (FIG. 8) through a first-1 contact hole CNT1a. The voltage transfer wiring 1610 may be electrically connected to the third conductive pattern 1310 (FIG. 12) through a first-2 contact hole CNT1b. The voltage transfer wiring 1610 may be electrically connected to the first silicon semiconductor pattern 1110 (FIG. 9) through a first-3 contact hole CNT1c. Through a structure in which the voltage transfer wiring 1610 is connected to the lower metal layer BML (FIG. 8) through the first-1 contact hole CNT1a, the lower metal layer BML (FIG. 8) may have a voltage level of the driving voltage ELVDD. The voltage transfer wiring 1610 may supply the driving voltage ELVDD to the upper electrode CE2 (FIG. 12) of the first capacitor Cst and the fifth semiconductor layer A5 (FIG. 11) of the operation control transistor T5 through the first-2 contact hole CNT1b and the first-3 contact hole CNT1c.

The first pixel connection electrode 1620 may be apart from the voltage transfer wiring 1610. The first pixel connection electrode 1620 may be electrically connected to the voltage transfer wiring 1610.

The first pixel connection electrode 1620 may be arranged in the same layer as the voltage transfer wiring 1610. The first pixel connection electrode 1620 may include a first-1 pixel connection electrode 1620a, a first-2 pixel connection electrode 1620b, and a first-3 pixel connection electrode 1620c respectively arranged in the first to third pixel circuits PC1, PC2, and PC3. Each of the first-1 pixel connection electrode 1620a, the first-2 pixel connection electrode 1620b, and the first-3 pixel connection electrode 1620c may be apart from the voltage transfer wiring 1610.

The first pixel connection electrode 1620 may be electrically connected to the first silicon semiconductor pattern 1110 (FIG. 9) through the second contact hole CNT2. For example, the first-1 pixel connection electrode 1620a may be electrically connected to the first silicon semiconductor pattern 1110 (FIG. 9) corresponding to the first pixel circuit PC1 through the second contact hole CNT2. The first pixel connection electrode 1620 may be electrically connected to the emission control transistor A6 (FIG. 9) of the emission control transistor T6 (FIG. 11) and/or the second initialization semiconductor layer A7 (FIG. 11) of the second initialization transistor T7 formed along the first silicon semiconductor pattern 1110 (FIG. 9).

The first connection electrode 1630, the second connection electrode 1640, the third connection electrode 1650, the fourth connection electrode 1660, and the fifth connection electrode 1670 may each have an isolated shape. The first connection electrode 1630, the second connection electrode 1640, the third connection electrode 1650, the fourth connection electrode 1660, and the fifth connection electrode 1670 may be arranged in each of the first to third pixel circuits PC1, PC2, and PC3.

The first connection electrode 1630 may electrically connect the first conductive pattern 1210 (FIG. 10) to the oxide semiconductor pattern 1410 (FIG. 13). The first connection electrode 1630 may be electrically connected to the first conductive pattern 1210 (FIG. 10) through a third-1 contact hole CNT3a. The first connection electrode 1630 may be electrically connected to the oxide semiconductor pattern 1410 (for example, the compensation semiconductor layer A3 of the compensation transistor T3) (FIG. 15) through a third-2 contact hole CNT3b. The first connection electrode 1630 may electrically connect the driving gate electrode G1 of the driving transistor T1 (FIG. 11) to the compensation semiconductor layer A3 of the compensation transistor T3 (FIG. 15). The first connection electrode 1630 may electrically connect the first capacitor Cst (FIG. 11) and the compensation transistor T3 (FIG. 15).

The first connection electrode 1630 may overlap a portion of the lower metal layer BML (FIG. 8), for example, the second branch portion BMLb.

The second connection electrode 1640 may electrically connect the first silicon semiconductor pattern 1110 (FIG. 9) to the oxide semiconductor pattern 1410 (FIG. 13). The second connection electrode 1640 may be electrically connected to the first silicon semiconductor pattern 1110 (FIG. 9) through a fourth-1 contact hole CNT4a. The second connection electrode 1640 may be electrically connected to the oxide semiconductor pattern 1410 (FIG. 13) through a fourth-2 contact hole CNT4b. The second connection electrode 1640 may electrically connect the driving semiconductor layer A1 (FIG. 11) of the driving transistor T1 to the compensation semiconductor layer A3 (FIG. 15) of the compensation transistor T3. The second connection electrode 1640 may electrically connect the emission control semiconductor layer A6 (FIG. 11) of the emission control transistor T6 to the compensation semiconductor layer A3 (FIG. 15) of the compensation transistor T3.

The third connection electrode 1650 may be electrically connected to the first silicon semiconductor pattern 1110 (FIG. 9) through a fifth contact hole CNT5. For example, the third connection electrode 1650 corresponding to the first pixel circuit PC1 may be electrically connected to the first data line DL1 described below with reference to FIG. 17. For example, the third connection electrode 1650 corresponding to the first pixel circuit PC1 may be configured to transmit the data signal applied to the first data line DL1 (FIG. 17) to the second semiconductor layer A2 (FIG. 11) of the data write transistor T2.

The fourth connection electrode 1660 may electrically connect the first silicon semiconductor pattern 1110 (FIG. 9) to the second silicon semiconductor pattern 1120 (FIG. 9). The fourth connection electrode 1660 may be electrically connected to the first silicon semiconductor pattern 1110 (FIG. 9) through a sixth-1 contact hole CNT6a. The fourth connection electrode 1660 may be electrically connected to the second silicon semiconductor pattern 1120 (FIG. 9) through a sixth-2 contact hole CNT6b. The fourth connection electrode 1660 may electrically connect the operation control semiconductor layer A5 (FIG. 11) of the operation control transistor T5 formed along the first silicon semiconductor pattern 1110 (FIG. 9) to the bias semiconductor layer A8 (FIG. 11) of the bias transistor T8 formed along the second silicon semiconductor pattern 1120 (FIG. 9).

The fifth connection electrode 1670 corresponding to the first pixel circuit PC1 may electrically connect the first silicon semiconductor pattern 1110 (FIG. 9) corresponding to the first pixel circuit PC1 to the second-1 initialization horizontal voltage line HVAL1 (FIG. 15). The fifth connection electrode 1670 corresponding to the first pixel circuit PCT1 may electrically connect the second initialization semiconductor layer A7 (FIG. 11) of the second initialization transistor T7 formed along the first silicon semiconductor pattern 1110 (FIG. 9) to the second-1 initialization horizontal voltage line HVAL1 (FIG. 15).

The fifth connection electrode 1670 corresponding to the first pixel circuit PC1 may be electrically connected to the second initialization semiconductor layer A7 (FIG. 11) of the second initialization transistor T7 corresponding to the first pixel circuit PC1 through a seventh-1 contact hole CNT7a and be electrically connected to the second-1 initialization horizontal voltage line HVAL1 (FIG. 15) through a seventh-2 contact hole CNT7b. The second-1 initialization horizontal voltage line HVAL1 (FIG. 15) may be configured to transmit the second-1 initialization voltage Vaint1 (FIG. 4) to the second initialization transistor T7 (FIG. 11) of the first pixel circuit PC1 through the fifth connection electrode 1670.

The fifth connection electrode 1670 corresponding to each of the second pixel circuit PC2 and the third pixel circuit PC3 may electrically connect the first silicon semiconductor pattern 1110 (FIG. 9) to the second-2 initialization horizontal voltage line HVAL2 (FIG. 11), both corresponding to each of the second pixel circuit PC2 and the third pixel circuit PC3. The fifth connection electrode 1670 corresponding to each of the second pixel circuit PC2 and the third pixel circuit PC3 may electrically connect the second initialization semiconductor layer A7 (FIG. 11) of the second initialization transistor T7 to the second-2 initialization horizontal voltage line HVAL2 (FIG. 11), both corresponding to each of the second pixel circuit PC2 and the third pixel circuit PC3.

The fifth connection electrode 1670 corresponding to each of the second pixel circuit PC2 and the third pixel circuit PC3 is electrically connected to the second initialization semiconductor layer A7 (FIG. 11) of the second initialization transistor T7 corresponding to each of the second pixel circuit PC2 and the third pixel circuit PC3 through the seventh-1 contact hole CNT7a. The fifth connection electrode 1670 corresponding to each of the second pixel circuit PC2 and the third pixel circuit PC3 may be electrically connected to the second-2 initialization horizontal voltage line HVAL2 (FIG. 11) through the seventh-2 contact hole CNT7b. The second-2 initialization horizontal voltage line HVAL2 (FIG. 11) may be configured to transmit the second-2 initialization voltage Vaint2 (FIG. 4) to the second initialization transistor T7 (FIG. 11) corresponding to each of the second pixel circuit PC2 and the third pixel circuit PC3 through the fifth connection electrode 1670 arranged in each of the second pixel circuit PC2 and the third pixel circuit PC3. In an embodiment, the second-1 initialization voltage and the second-2 initialization voltage may have the same voltage level.

The bridge pattern 1680 may have an isolated shape. The bridge pattern 1680 may be arranged between the second pixel circuit PC2 and the third pixel circuit PC3. The bridge pattern 1680 may be arranged in the gap space IVA. The bridge pattern 1680 may overlap the vertical voltage line VCL (FIG. 7) described below. The bridge pattern 1680 may be a connection electrode electrically connecting the vertical voltage line VCL (FIG. 7) to the horizontal voltage line. For example, the bridge pattern 1680 electrically connected to the vertical voltage line VCL (FIG. 7) may be electrically connected to the first initialization horizontal voltage line HVIL. To this end, an end of the sub-bridge pattern 1340 (FIG. 12) may be connected to the bridge pattern 1680 through a thirteenth-1 contact hole CNT13a, and the other end of the sub-bridge pattern 1340 may be connected to the first initialization horizontal voltage line HVIL through a thirteenth-2 contact hole CNT13b.

The first initialization control line GIL, the scan line GWL, the compensation scan line GCL, the bias voltage line VOL, the first initialization horizontal voltage line HVIL each may extend in the first direction (for example, the ±x direction).

The first initialization control line GIL may be electrically connected to the fifth conductive pattern 1330 (FIG. 15) and the seventh conductive pattern 1520 (FIG. 15) of each of the first to third pixel circuits PC1, PC2, and PC3. The first initialization control line GIL may be electrically connected to the fifth conductive pattern 1330 (FIG. 15) of each of the first to third pixel circuits PC1, PC2, and PC3 through an eighth-1 contact hole CNT8a. The first initialization control line GIL may be electrically connected to the seventh conductive pattern 1520 (FIG. 15) of each of the first to third pixel circuits PC1, PC2, and PC3 through an eighth-2 contact hole CNT8b. The first initialization control line GIL may supply the first initialization control signal GI (FIG. 3) to each of the fifth conductive pattern 1330 (FIG. 15), which is the lower first initialization gate electrode G4a of the first initialization transistor T4 and the seventh conductive pattern 1520 (FIG. 15), which is the upper first initialization gate electrode G4b of the first initialization transistor T4.

The scan line GWL may be electrically connected to the second conductive pattern 1220 (FIG. 11) of each of the first to third pixel circuits PC1, PC2, and PC3 through a ninth contact hole CNT9. The scan line GWL may provide the scan signal GW (FIG. 3) to the second conductive pattern 1220 (FIG. 11), which is the data write gate electrode G2 (FIG. 11) of the data write transistor T2 (FIG. 11) of each of the first to third pixel circuits PC1, PC2, and PC3.

The compensation scan line GCL may be electrically connected to the fourth conductive pattern 1320 (FIG. 15) and the sixth conductive pattern 1510 (FIG. 15) of each of the first to third pixel circuits PC1, PC2, and PC3. The compensation scan line GCL may be electrically connected to the fourth conductive pattern 1320 (FIG. 15) of each of the first to third pixel circuits PC1, PC2, and PC3 through a tenth-1 contact hole CNT10a. The compensation scan line GCL may be electrically connected to the sixth conductive pattern 1510 (FIG. 15) of each of the first to third pixel circuits PC1, PC2, and PC3 through a tenth-2 contact hole CNT10b. The compensation scan line GCL may provide the scan signal GC (FIG. 3) to each of the fourth conductive pattern 1320 (FIG. 15), which is the lower compensation gate electrode G3a of the compensation transistor T3 and the sixth conductive pattern 1510 (FIG. 15), which is the upper compensation gate electrode G3b of the compensation transistor T3.

The bias voltage line VOL may be electrically connected to the second silicon semiconductor pattern 1120 (FIG. 11) of each of the first to third pixel circuits PC1, PC2, and PC3 through an eleventh contact hole CNT11. The bias voltage line VOL may provide the bias voltage Vobs (FIG. 3) to the bias semiconductor layer A8 (FIG. 11) of the bias transistor T8 of each of the first to third pixel circuits PC1, PC2, and PC3.

The first initialization horizontal voltage line HVIL may be electrically connected to the oxide semiconductor pattern 1410 (FIG. 15) of each of the first to third pixel circuits PC1, PC2, and PC3 through a twelfth contact hole CNT12. For example, the first initialization voltage Vint (FIG. 3) may be provided to the first initialization transistor T4 (FIG. 15) formed along the oxide semiconductor pattern 1410 (FIG. 15).

Referring to FIGS. 6 and 17, the first organic insulating layer 121 (FIG. 6) may be disposed on the fourth conductive layer 1600 and a fifth conductive layer 1700 may be disposed on the first organic insulating layer 121 (FIG. 6). The fifth conductive layer 1700 may include a second pixel connection electrode 1710, the driving voltage line PL, the first data line DL1, the second data line DL2, the third data line DL3, and the vertical voltage line VCL.

Referring to FIG. 17, the driving voltage line PL, the first data line DL1, the second data line DL2, the third data line DL3, and the vertical voltage line VCL may extend in the second direction (for example, the ±y direction). The driving voltage line PL, the first data line DL1, the second data line DL2, the third data line DL3, the vertical voltage line VCL, and the second pixel connection electrode 1710 may include a same material.

The driving voltage line PL, the first data line DL1, the second data line DL2, the third data line DL3, the vertical voltage line VCL, and the second pixel connection electrode 1710 may include at least one material selected from Al, Pt, Pd, Ag, Mg, Au, Ni, Nd, Ir, Cr, Li, Ca, Mo, Ti, W, and Cu.

The driving voltage line PL may be arranged in each of the first to third pixel circuits PC1, PC2, and PC3. The driving voltage line PL corresponding to one of the first to third pixel circuits PC1, PC2, and PC3 may be electrically connected to the voltage transfer wiring 1610 (FIG. 16) through a fifteenth contact hole CNT15. The shape and area of the driving voltage line PL arranged in each the first to third pixel circuits PC1, PC2, and PC3 may be different from each other.

The driving voltage line PL arranged in each of the first to third pixel circuits PC1, PC2, and PC3 may overlap the gate electrode of the compensation transistor T3 of each of the first to third pixel circuits PC1, PC2, and PC3, for example, the lower compensation gate electrode G3a and the upper compensation gate electrode G3b of FIG. 15, and may overlap the first connection electrode 1630 (FIG. 16) corresponding to each of the first to third pixel circuits PC1, PC2, and PC3. The overlapping structure described above may prevent unnecessary parasitic capacitance from affecting the compensation transistor T3 and the first connection electrode 1630. In a plan view as shown in FIG. 17, since the first connection electrode 1630 (FIG. 16) overlaps the second branch portion BMLb of the lower metal layer BML (FIG. 8) and the driving voltage line PL, both having voltage levels of the same constant voltage (for example, the driving voltage ELVDD level), an occurrence of the parasitic capacitance described above may be prevented more effectively.

The first data line DL1, the second data line DL2, and the third data line DL3 may be electrically connected to the data write transistor T2 (FIG. 11) of each of the first pixel circuit PC1, the second pixel circuit PC2, and the third pixel circuit PC3. The first to third data lines DL1, DL2, and DL3 may be configured to transmit the data signal Dm (FIG. 3) to each of the first to third pixel circuits PC1, PC2, and PC3.

The first data line DL1 may be electrically connected to the third connection electrode 1650 (FIG. 16) corresponding to the first pixel circuit PC1 through a sixteenth contact hole CNT16. Likewise, the second data line DL2 may be electrically connected to the third connection electrode 1650 (FIG. 16) corresponding to the second pixel circuit PC2 through the sixteenth contact hole CNT16, and the third data line DL3 may be electrically connected to the third connection electrode 1650 (FIG. 16) corresponding to the third pixel circuit PC3 through the sixteenth contact hole CNT16. Since the third connection electrode 1650 (FIG. 16) corresponding to each first to third pixel circuits PC1, PC2, and PC3 is electrically connected to the first silicon semiconductor pattern 1110 (FIG. 11) of the corresponding pixel circuit, the data signal Dm (FIG. 3) may be provided to the data write transistor T2 (FIG. 11) formed along the first silicon semiconductor pattern 1110 (FIG. 11).

In a plan view, the shape of each of the first data line DL1, the second data line DL2, and the third data line DL3 may be different from each other. For example, the first data line DL1 and the second data line DL2 may cross an area corresponding to the second pixel circuit PC2 while having different planar shapes. For example, the first data line DL1 and the second data line DL2 may be asymmetrical with respect to a virtual line along the second direction (for example, the ±y direction) between the first data line DL1 and the second data line DL2. The planar shape of the third data line DL3 may be different from the planar shape of each of the first data line DL1 and the second data line DL2.

The vertical voltage line VCL may be arranged in a gap space IVA between the second pixel circuit PC2 and the third pixel circuit PC3. For example, the vertical voltage line VCL may be arranged between the second data line DL2 and the driving voltage line PL of the third pixel circuit PC3.

The vertical voltage line VCL may be electrically connected to the horizontal voltage line extending in the first direction (for example, the ±x direction). In an embodiment, in case that the vertical voltage line VCL is the first initialization vertical voltage line VVIL (FIG. 5), the vertical voltage line VCL may be electrically connected to the first initialization horizontal voltage line HVIL (FIG. 16). For example, the vertical voltage line VCL may be connected to the bridge pattern 1680 (FIG. 16) through a seventeenth contact hole CNT17, the bridge pattern 1680 (FIG. 16) may be connected to the sub-bridge pattern 1340 (FIG. 12) through a thirteenth-1 contact hole CNT13a (FIG. 16), and the sub-bridge pattern 1340 (FIG. 16) may be electrically connected to the first initialization horizontal voltage line HVIL through a thirteenth-2 contact hole CNT13b (FIG. 16).

The second pixel connection electrode 1710 may be electrically connected to the first pixel connection electrode 1620 (FIG. 16). For example, a second-1 pixel connection electrode 1710a may be electrically connected to the first-1 pixel connection electrode 1620a (FIG. 16) through a fourteenth-1 contact hole CNT14a. For example, a second-2 pixel connection electrode 1710b may be electrically connected to the first-2 pixel connection electrode 1620b (FIG. 16) through a fourteenth-2 contact hole CNT14b. For example, a second-3 pixel connection electrode 1710c may be electrically connected to the first-3 pixel connection electrode 1620c (FIG. 16) through a fourteenth-3 contact hole CNT14c.

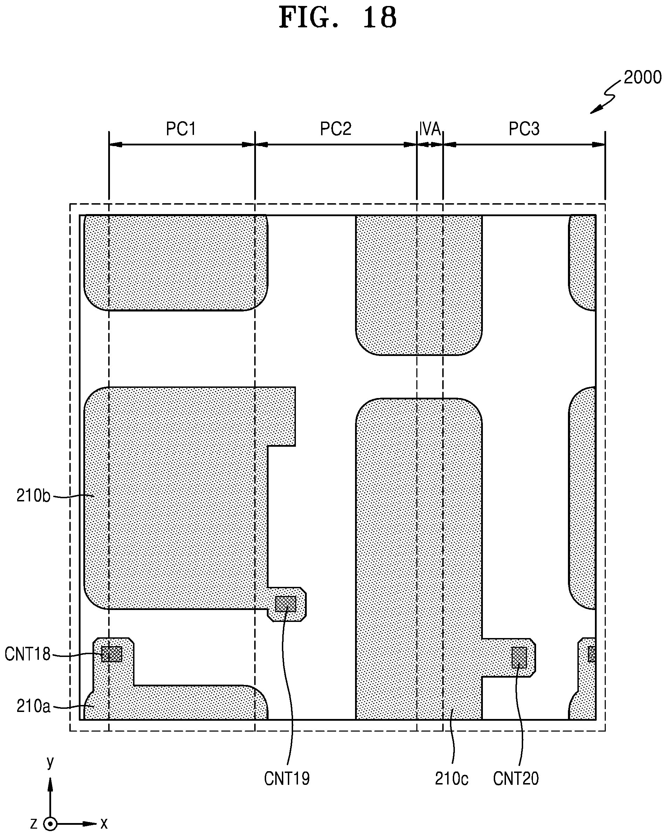

The second organic insulating layer 123 (FIG. 6) may be disposed on the structure described with reference to FIG. 17. Subsequently, the pixel electrodes as shown in FIG. 18 may be arranged in the second organic insulating layer 123 (FIG. 6).

Referring to FIG. 18, the first pixel electrode 210a electrically connected to the first pixel circuit PC1, the second pixel electrode 210b electrically connected to the second pixel circuit PC2, and the third pixel electrode 210c electrically connected to the third pixel circuit PC3 may be apart from each other. In an embodiment, the first pixel electrode 210a and the second pixel electrode 210b may be alternately arranged in the same column along the second direction (for example, the y direction). The third pixel electrodes 210c may be arranged in a column adjacent to a column in which the first pixel electrode 210a and the second pixel electrode 210b are arranged.

The pixel electrodes may be electrically connected to each of the first to third pixel circuits PC1, PC2, and PC3 through the second pixel connection electrode 1710 (FIG. 17) and the first pixel connection electrode 1620 (FIG. 16). The first pixel electrode 210a may be connected to the second-1 pixel connection electrode 1710a (FIG. 17) through an eighteenth contact hole CNT18 and the second-1 pixel connection electrode 1710a (FIG. 17) may be electrically connected to the first-1 pixel connection electrode 1620a (FIG. 16) through the fourteenth-1 contact hole CNT14a (FIG. 17). The second pixel electrode 210b may be connected to the second-2 pixel connection electrode 1710b (FIG. 17) through a nineteenth contact hole CNT19 and the second-2 pixel connection electrode 1710b (FIG. 17) may be electrically connected to the first-2 pixel connection electrode 1620b (FIG. 16) through the fourteenth-2 contact hole CNT14b (FIG. 17). The third pixel electrode 210c may be connected to the second-3 pixel connection electrode 1710c (FIG. 17) through a twentieth contact hole CNT20 and the second-3 pixel connection electrode 1710c (FIG. 17) may be electrically connected to the first-3 pixel connection electrode 1620c (FIG. 16) through the fourteenth-3 contact hole CNT14c (FIG. 17).

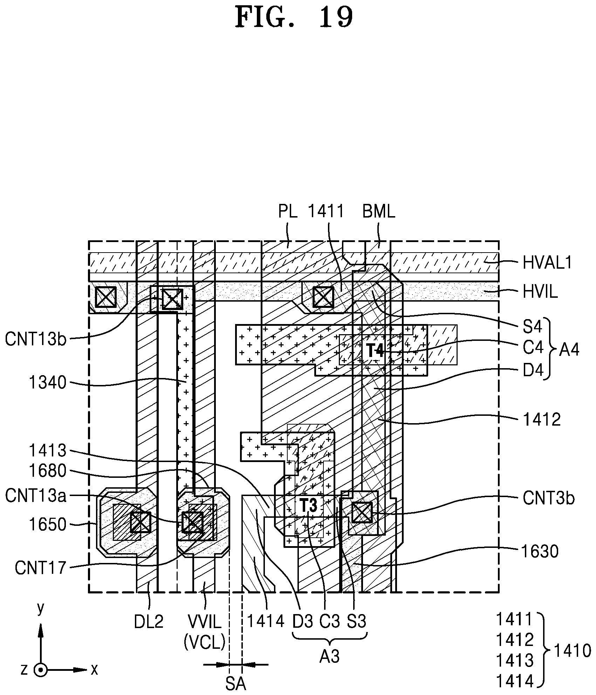

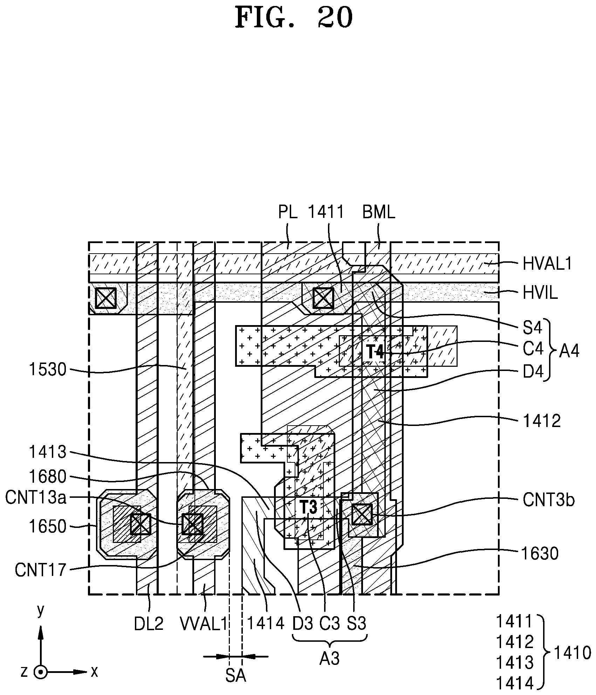

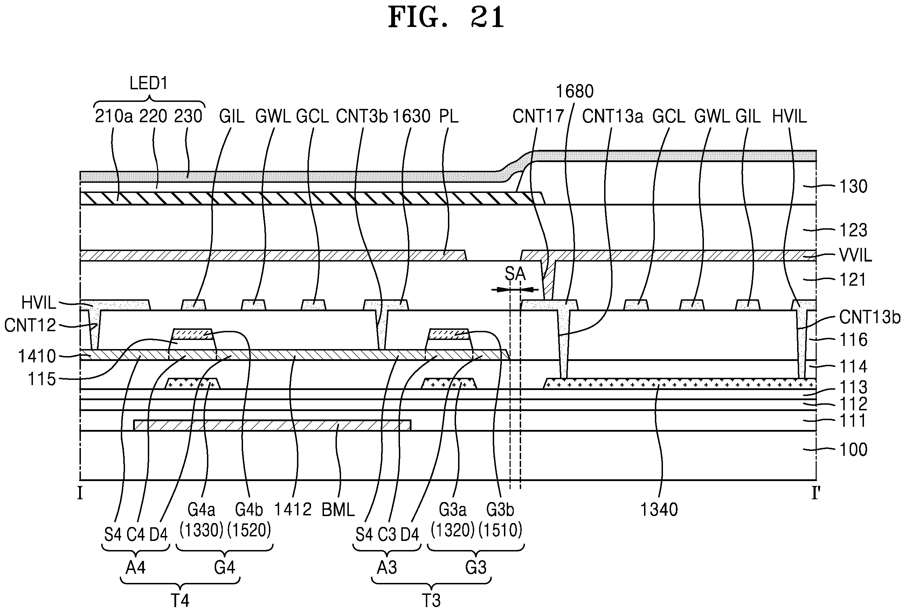

FIGS. 19 and 20 are enlarged schematic plan views of a portion of the display device according to an embodiment. FIG. 21 is a schematic plan view of the display device according to an embodiment. FIG. 19 is an enlarged view of an area in which the first initialization vertical voltage line VVIL is arranged in the gap space IVA (FIG. 17) and FIG. 20 is an area in which the second-1 initialization vertical voltage line VVAL is arranged in the gap space IVA (FIG. 17). FIG. 21 is a cross-sectional view of the display device taken along line I-I' of FIG. 7. For convenience of explanation, FIGS. 19 and 20 show a number of the components.

First, referring to FIGS. 19 and 20, the oxide semiconductor pattern 1410 may be arranged in the display area DA (FIG. 1). The oxide semiconductor pattern 1410 may have a bent shape. The oxide semiconductor pattern 1410 may include the first portion 1411, the second portion 1412 (or the first extension area), the third portion 1413, and the fourth portion 1414 (or the second extension area). The first portion 1411, the second portion 1412, the third portion 1413, and the fourth portion 1414 may be integral with each other.

The first portion 1411 may be arranged at the top of the oxide semiconductor pattern 1410 in the second direction (for example, the ±y direction). The first portion 1411 may extend in the first direction (for example, the ±x direction). The first portion 1411 may be connected to the first initialization horizontal voltage line HVIL and may be configured to transmit a voltage to the first initialization transistor T4. For example, the first portion 1411 may include a portion corresponding to a source area S4 of the first initialization semiconductor layer A4.

The second portion 1412 (or the first extension area) may be connected to the first portion 1411 and extend in the second direction (for example the ±y direction). The second portion 1412 may include a portion corresponding to the first initialization semiconductor layer A4. For example, the second portion 1412 may include a portion corresponding to a channel area C4 and a drain area D4 of the first initialization semiconductor layer A4. The second portion 1412 may extend from the channel area C4 of the first initialization semiconductor layer A4 to the first connection electrode 1630.

The third portion 1413 may be connected to the second portion 1412 and may extend in the first direction (for example, the ±x direction). The third portion 1413 may include a portion corresponding to the compensation semiconductor layer A3. For example, the third portion 1413 may include a portion corresponding to a source area S3 and the channel area C3 of the compensation semiconductor layer A3. The third portion 1413 may extend from the first connection electrode 1630 to a drain area D3 of the compensation semiconductor layer A3.

The fourth portion 1414 (or the second extension area) may be connected to the third portion 1413 and extend in the second direction (for example the ±y direction). The fourth portion 1414 may include a portion corresponding to the drain area D3 of the compensation semiconductor layer A3. The fourth portion 1414 may extend from the drain area D3 of the compensation semiconductor layer A3 to the second connection electrode 1640 (FIG. 16).

Referring to FIGS. 19 to 21, the second portion 1412 of the oxide semiconductor pattern 1410 may overlap a first shield layer disposed below the lower portion of the oxide semiconductor pattern 1410 and a second shield layer disposed over the oxide semiconductor pattern 1410.

In an embodiment, the first shield layer may be the lower metal layer BML. For example, the second portion 1412 of the oxide semiconductor pattern 1410 may overlap the lower metal layer BML. For example, the second portion 1412 of the oxide semiconductor pattern 1410 may overlap the second branch portion BMLb of the lower metal layer BML. In an embodiment, the second shield layer may be the fifth conductive layer 1700 (FIG. 17). For example, the second portion 1412 of the oxide semiconductor pattern 1410 may overlap the driving voltage line PL.

In other words, an upper surface of the second portion 1412 may be blocked from light by the driving voltage line PL and a lower surface of the second portion 1412 may be blocked from light by the lower metal layer BML. The second portion 1412 of the oxide semiconductor pattern 1410 may extend from the channel area C4 of the first initialization semiconductor layer A4 to the first connection electrode 1630 and may be configured to transmit the first initialization voltage Vint (FIG. 3) to the gate electrode G1 (FIG. 11) of the driving transistor T1 (FIG. 11). In case that ultraviolet light penetrates into the second portion 1412, a wiring resistance of the second portion 1412 including the oxide semiconductor may be increased, which may cause the image quality to be reduced due to a failure to initialize the potential of the gate electrode G1 (FIG. 11) of the driving transistor T1 (FIG. 11).

Accordingly, in the display device according to an embodiment, the lower metal layer BML and the driving voltage line PL are arranged to overlap the second portion 1412 of the oxide semiconductor pattern 1410, thereby protecting the second portion 1412 from ultraviolet light, etc. Since the second portion 1412 overlaps the lower metal layer BML and the driving voltage line PL having voltage levels of the same constant voltage, the second portion 1412 may be prevented from being affected by unnecessary parasitic capacitance. Thus, since the display device according to an embodiment may prevent an increase in the resistance of the oxide semiconductor pattern 1410 and occurrence of unnecessary parasitic capacitance, an image of excellent quality may be implemented.

Referring again to FIGS. 19 and 20, the vertical voltage line VCL may be arranged in the gap space IVA (FIG. 17) of the display area DA (FIG. 1). As described above, the vertical voltage line VCL may include the first initialization vertical voltage line VVIL, the second-1 initialization vertical voltage line VVAL1, the second-2 initialization vertical voltage line VVAL2 (FIG. 5), and the common voltage line VSL (FIG. 5).

The vertical voltage line VCL may be electrically connected to a horizontal voltage line corresponding thereto. For example, as shown in FIG. 19, the first initialization vertical voltage line VVIL may be connected to the first initialization horizontal voltage line HVIL. By way of example, as shown in FIG. 20, the second-1 initialization vertical voltage line VVAL1 may be electrically connected to the second-1 initialization horizontal voltage line HVAL1 (FIG. 5).

The vertical voltage line VCL may be electrically connected to a horizontal voltage line corresponding thereto through an additional connection electrode. First, referring to FIG. 19, the first initialization vertical voltage line VVIL may be connected to the bridge pattern 1680 through the seventeenth contact hole CNT17, the bridge pattern 1680 may be connected to an end of the sub-bridge pattern 1340 through the thirteenth-1 contact hole CNT13a, and the other end of the sub-bridge pattern 1340 may be connected to the first initialization horizontal voltage line HVIL through the thirteenth-2 contact hole CNT13b. For example, the first initialization vertical voltage line VVIL may be connected to the first initialization horizontal voltage line HVIL through the bridge pattern 1680 and the sub-bridge pattern 1340.

Likewise, referring to FIG. 20, the second-1 initialization vertical voltage line VVAL1 may be connected to the bridge pattern 1680 through the seventeenth contact hole CNT17. The bridge pattern 1680 may be connected to an eighth conductive pattern 1530 through the thirteenth-1 contact hole CNT13a. The eighth conductive pattern 1530 is included in the third conductive layer 1500 (FIG. 14) and may be integral to the second-1 initialization horizontal voltage line HVAL1. For example, the second-1 initialization vertical voltage line VVAL1 may be connected to the second-1 initialization horizontal voltage line HVAL1 through the bridge pattern 1680 and the eighth conductive pattern 1530.

Referring to FIGS. 19 to 21, the bridge pattern 1680 and the oxide semiconductor pattern 1410 having the above structure may not overlap each other. In an embodiment, the oxide semiconductor pattern 1410 may be apart from the bridge pattern 1680 in a plane. For example, the bridge pattern 1680 may be arranged slightly apart from the fourth portion 1414 of the oxide semiconductor pattern 1410. In other words, a gap area SA may be present between the bridge pattern 1680 and the oxide semiconductor pattern 1410.

By way of example, in an embodiment, the bridge pattern 1680 may slightly overlap the oxide semiconductor pattern 1410. However, in the embodiment, a portion of the fourth portion 1414 of the oxide semiconductor pattern 1410 overlaps the bridge pattern 1680 and most of the upper surface of the fourth portion 1414 may not overlap the bridge pattern 1680.

The quality of the display device according to an embodiment may be improved as the bridge pattern 1680 and the oxide semiconductor pattern 1410 are arranged so as to not overlap each other. For example, in case that the oxide semiconductor pattern 1410 overlaps the bridge pattern 1680, since the bridge pattern 1680 receives a voltage of a low level from the vertical voltage line VCL, the bridge pattern 1680 may affect an adjacent compensation transistor T3 such that the adjacent compensation transistor T3 does not operate normally. For example, in case that the bridge pattern 1680 overlaps the fourth portion 1414, the resistance of the oxide semiconductor pattern 1410 may be increased, resulting in an image quality defect. On the other hand, as shown in FIGS. 19 to 21, in case that the bridge pattern 1680 and the oxide semiconductor pattern 1410 are apart from each other, the bridge pattern 1680 receiving a low level of voltage may not affect the oxide semiconductor pattern 1410. Thus, since the display device according to an embodiment may prevent an increase in the resistance of the oxide semiconductor pattern 1410 and abnormal operation of the compensation transistor T3, an image of excellent quality may be implemented.

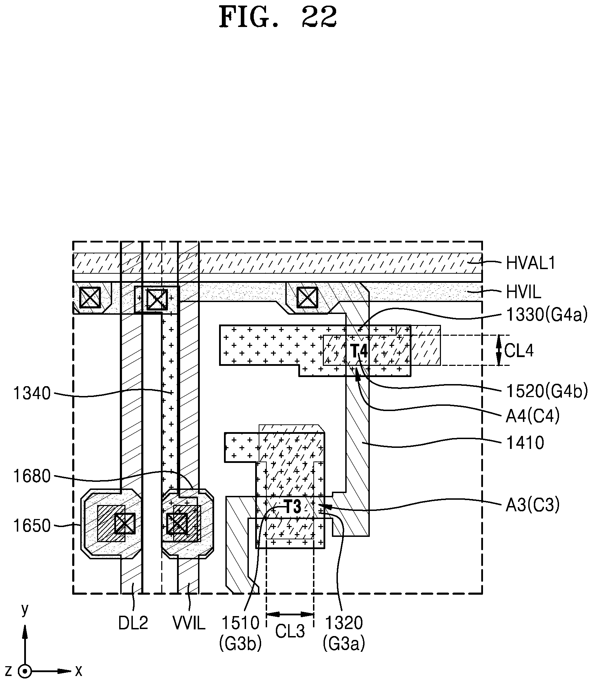

FIG. 22 is an enlarged schematic plan view of a portion of the display device 1 according to an embodiment. Referring to FIG. 22, the features of the components excluding those of the compensation transistor T3 are as described in FIGS. 7 to 21. For components of FIG. 22 with the same reference numbers as those of FIGS. 7 to 21, descriptions are as detailed in FIGS. 7 to 21, and differences are described below. For convenience of explanation, FIG. 22 shows a number of the components.

Referring to FIG. 22, the first to third pixel circuits PC1, PC2, and PC3 (FIG. 7) may each include the compensation transistor T3 and the first initialization transistor T4. The compensation transistor T3 may include a compensation gate electrode and the compensation semiconductor layer A3 and the compensation gate electrode may include the lower compensation gate electrode G3a and the upper compensation gate electrode G3b. The first initialization transistor T4 may include the first initialization gate electrode G4 and the first initialization semiconductor layer A4, and the first initialization gate electrode G4 may include the lower first initialization gate electrode G4a and the upper first initialization gate electrode G4b.

The compensation semiconductor layer A3 and the first initialization semiconductor layer A4 may be oxide semiconductor layers and may be integral with each other. The compensation semiconductor layer A3 may include the channel area C3 and impurity areas arranged on both sides of the channel area C3 and doped with impurities, and the first initialization semiconductor layer A4 may include the channel area C4 and impurity areas arranged on both sides of the channel area C4.

In an embodiment, a ratio W/L of a channel width to a channel length of the compensation transistor T3 may be different from a ratio W/L of a channel width to a channel length of the first initialization transistor T4. For example, as shown in FIG. 22, a channel length CL3 of the compensation transistor T3 may be greater than a channel length CL4 of the first initialization transistor T4. For example, a length of a width in the first direction (for example, the ±x direction) of the fourth conductive pattern 1320 forming the lower compensation gate electrode G3a of the compensation transistor T3 may be greater than a length of a width in the second direction (for example, the ±y direction) of the fifth conductive pattern 1330 forming the lower first initialization gate electrode G4a of the first initialization transistor T4. Likewise, a length of a width in the first direction (for example, the ±x direction) of the sixth conductive pattern 1610 forming the upper compensation gate electrode G3b of the compensation transistor T3 may be greater than a length of a width in the second direction (for example, the ±y direction) of the seventh conductive pattern 1520 forming the upper first initialization gate electrode G4b of the first initialization transistor T4.

The compensation transistor T3 may be turned on by a compensation signal and connect the gate electrode and the second electrode of the driving transistor T1 (FIG. 11) to each other, thereby diode-connecting the driving transistor T1. Accordingly, a voltage difference equal to the threshold voltage may occur between the first electrode and the gate electrode of the driving transistor T1, and a threshold voltage deviation of the driving transistor T1 may be compensated by providing the data signal of which the threshold voltage is compensated to the gate electrode of the driving transistor T1.

The compensation transistor T3 needs to be completely turned off after the threshold voltage of the driving transistor T1 (FIG. 11) is compensated. However, since a parasitic capacitance is formed between the compensation gate electrode of the compensation transistor T3 and the source area of the compensation semiconductor layer A3, a change in a charge amount due to the parasitic capacitance may cause a change in the voltage in the driving gate electrode G1 (FIG. 11) of the driving transistor T1 and an occurrence of a kick-back phenomenon in the display device. The kick-back phenomenon refers to a flickering phenomenon in which the screen of the display device keeps blinking or to an image sticking phenomenon, which may cause a quality deterioration of the display device.

For example, in the display device according to an embodiment, the channel area of the compensation transistor T3 and the first initialization transistor T4 may be designed differently to adjust a kick-back voltage. The kick-back voltage is a change in the amount of voltage of the gate electrode of the driving transistor T1 (FIG. 11) and may be proportional to the amount of the parasitic capacitance of the compensation transistor T3. For example, as shown in FIG. 22, in case that the channel length CL3 of the compensation transistor T3 is greater than the channel length CL4 of the first initialization transistor T4, the compensation transistor T3 may have a greater W/L ratio than the first initialization transistor T4, and thus, the parasitic capacitance and the kick-back voltage of the compensation transistor T3 may change. For example, in the display device according to an embodiment, as the compensation transistor T3 and the first initialization transistor T4 are designed differently, the kick-back voltage may be adjusted to control or prevent the kick-back phenomenon and to improve the mid/long term image sticking figure of merit (ISFOM).

As described above, the display device according to an embodiment may prevent an increase in the resistance of the semiconductor layer and implement an image of high quality. However, the embodiments are examples, and do not limit the scope of the invention.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope and as defined by the following claims.

## Claims

1. A display device (1) comprising:
a first pixel circuit (PC1) disposed on a substrate (100); and
a first light-emitting diode (LED1) electrically connected to the first pixel circuit (PC1), wherein
the first pixel circuit (PC1) comprises:
a driving transistor (T1) comprising a driving semiconductor layer (A1) and a driving gate electrode (G1);
a first initialization transistor (T4) including a first initialization semiconductor layer (A4) and a first initialization gate electrode (G4) and electrically connected to the driving transistor (T1); and
a first connection electrode (1630) electrically connecting the first initialization semiconductor layer (A4) to the driving gate electrode (G1),
a semiconductor layer comprising the first initialization semiconductor layer (A4) comprises a first extension area (1412) extending from a channel area (C4) of the first initialization semiconductor layer (A4) to the first connection electrode (1630), and
the first extension area (1412) overlaps a first shield layer disposed under the first initialization semiconductor layer (A4) and a second shield layer disposed above the first initialization semiconductor layer (A4).

2. The display device (1) of claim 1, wherein the first shield layer is disposed between an upper surface of the substrate (100) and the driving transistor (T1).

3. The display device (1) of claim 1 or 2, wherein the first shield layer overlaps the channel area (C4) of the driving transistor (T1) and the first connection electrode (1630).

4. The display device (1) of at least one of claims 1 to 3, wherein the second shield layer is disposed between the first connection electrode (1630) and the first light-emitting diode (LED1).

5. The display device (1) of at least one of claims 1 to 4, further comprising:
a driving voltage line (PL) that transmits a driving voltage to the first pixel circuit (PC1) and extending across the first pixel circuit (PC1),
wherein the second shield layer comprises the driving voltage line (PL).

6. The display device (1) of at least one of claims 1 to 5, wherein
the driving semiconductor layer (A1) and the first initialization semiconductor layer (A4) are disposed on different layers,
the driving semiconductor layer (A1) comprises a silicon semiconductor layer (1100), and
the first initialization semiconductor layer (A4) comprises an oxide semiconductor layer (1400).

7. The display device (1) of at least one of claims 1 to 6, further comprising:
a second pixel circuit (PC2) adjacent to the first pixel circuit (PC1) in a first direction;
a third pixel circuit (PC3) facing the first pixel circuit (PC1) with the second pixel circuit (PC2) disposed between the third pixel circuit (PC3) and the first pixel circuit (PC1); and
a vertical voltage line (VCL) disposed between the second pixel circuit (PC2) and the third pixel circuit (PC3) and extending in a second direction intersecting the first direction.

8. The display device (1) of claim 7, further comprising:
a second light-emitting diode (LED2) electrically connected to the second pixel circuit (PC2); and
a third light-emitting diode (LED3) electrically connected to the third pixel circuit (PC3),
wherein the first light-emitting diode (LED1) emits red light, the second light-emitting diode (LED2) emits green light, and the third light-emitting diode (LED3) emits blue light.

9. The display device (1) of claim 7 or 8, wherein the vertical voltage line (VCL) and the second shield layer are disposed on a same layer.

10. The display device (1) of at least one of claims 7 to 9, further comprising:
a horizontal voltage line (HVIL) electrically connected to the vertical voltage line (VCL) and extending in the first direction; and
a bridge pattern (1680) electrically connecting the vertical voltage line (VCL) to the horizontal voltage line (HVIL),
wherein the bridge pattern (1680) and the first connection electrode (1630) are disposed on a same layer.

11. The display device (1) of claim 10, wherein
the third pixel circuit (PC3) comprises a silicon semiconductor layer (1100) and an oxide semiconductor layer (1400), and,
the oxide semiconductor layer (1400) of the third pixel circuit (PC3) is spaced apart from the bridge pattern (1680) when viewed from a direction vertical to the substrate (100).

12. The display device (1) of claim 10 or 11, wherein
the third pixel circuit (PC3) comprises:
a driving transistor (T1);
a compensation transistor (T3) comprising a compensation semiconductor layer (A3) and a compensation gate electrode (G3) and electrically connected to the driving transistor (T1) of the third pixel circuit (PC3);
an emission control transistor (T6) comprising an emission control semiconductor layer (A6) and an emission control gate electrode (G6) and electrically connected to the driving transistor (T1) of the third pixel circuit (PC3); and
a second connection electrode (1640) electrically connecting the compensation transistor (T3) to the driving transistor (T1) of the third pixel circuit (PC3) and the compensation transistor (T3) to the emission control transistor (T6),
a semiconductor layer comprising the compensation semiconductor layer (A3) comprises a second extension area (1414) extending from a drain area (D3) of the compensation semiconductor layer (A3) to the second connection electrode (1640), and
the bridge pattern (1680) and the second extension area (1414) are spaced apart from each other.

13. The display device (1) of at least one of claim 1 to 12, wherein
the first pixel circuit (PC1) further comprises a compensation transistor (T3) comprising a compensation semiconductor layer (A3) and a compensation gate electrode (G3) and electrically connected to the driving transistor (T1),
wherein the first initialization semiconductor layer (A4) and the compensation semiconductor layer (A3) are integral with each other.

14. The display device (1) of claim 12 or 13, wherein a ratio of a channel width to a channel length (CL4) of the first initialization transistor (T4) is different from a ratio of a channel width to a channel length (CL3) of the compensation transistor (T3), especially wherein a channel length (CL3) of the compensation transistor (T3) is greater than a channel length (CL4) of the first initialization transistor (T4).

15. A display device (1) comprising:
a first pixel circuit (PC1) disposed on a substrate (100);
a second pixel circuit (PC2) adjacent to the first pixel circuit (PC1) in a first direction;
a third pixel circuit (PC3) facing the first pixel circuit (PC1) with the second pixel circuit (PC2) disposed between the third pixel circuit (PC3) and the first pixel circuit (PC1);
a vertical voltage line (VCL) disposed in a gap area between the second pixel circuit (PC2) and the third pixel circuit (PC3) and extending in a second direction intersecting the first direction;
a horizontal voltage line (HVIL) electrically connected to the vertical voltage line (VCL) and extending in the first direction; and
a bridge pattern (1680) electrically connecting the vertical voltage line (VCL) to the horizontal voltage line (HVIL), wherein
each of the first pixel circuit (PC1), the second pixel circuit (PC2), and the third pixel circuit (PC3) comprises a silicon semiconductor layer (1100) and an oxide semiconductor layer (1400), and
the oxide semiconductor layer (1400) of the third pixel circuit (PC3) is spaced apart from the bridge pattern (1680) when viewed from a direction vertical to the substrate (100).

16. The display device (1) of claim 15, further comprising:
a first light-emitting diode (LED1) electrically connected to the first pixel circuit (PC1);
a second light-emitting diode (LED2) electrically connected to the second pixel circuit (PC2); and
a third light-emitting diode (LED3) electrically connected to the third pixel circuit (PC3),
wherein the first light-emitting diode (LED1) emits red light, the second light-emitting diode (LED2) emits green light, and the third light-emitting diode (LED3) emits blue light.

17. The display device (1) of claim 15 or 16, wherein
each of the first pixel circuit (PC1), the second pixel circuit (PC2), and the third pixel circuit (PC3) further comprises:
a driving transistor (T1) comprising a driving gate electrode (G1) and a driving semiconductor layer (A1) included in the silicon semiconductor layer (1100);
a first initialization transistor (T4) comprising a first initialization gate electrode (G4) and a first initialization semiconductor layer (A4) included in the oxide semiconductor layer (1400), the first initialization transistor (T4) being electrically connected to the driving transistor (T1); and
a first connection electrode (1630) electrically connecting the first initialization semiconductor layer (A4) to the driving gate electrode (G1),
the oxide semiconductor layer (1400) comprises a first extension area (1412) extending from a channel area (C4) of the first initialization semiconductor layer (A4) to the first connection electrode (1630), and
the first extension area (1412) overlaps a first shield layer disposed under the oxide semiconductor layer (1400) and a second shield layer disposed above the oxide semiconductor layer (1400).

18. The display device (1) of claim 17, wherein the first shield layer comprises a lower metal layer (BML) disposed between an upper surface of the substrate (100) and the driving transistor (T1).

19. The display device (1) of claim 17 or 18, further comprising:
a driving voltage line (PL) disposed on a same layer as the vertical voltage line (VCL) and spaced apart from the vertical voltage line (VCL),
wherein the second shield layer comprises the driving voltage line (PL).

20. The display device (1) of at least one of claims 17 to 19, wherein
each of the first pixel circuit (PC1), the second pixel circuit (PC2), and the third pixel circuit (PC3) further comprises a compensation transistor (T3) comprising a compensation gate electrode (G3) and a compensation semiconductor layer (A3) included in the oxide semiconductor layer (1400), the compensation transistor (T3) being electrically connected to the driving transistor (T1), and
a ratio of a channel width to a channel length (CL4) of the first initialization transistor (T4) is different from a ratio of a channel width to a channel length (CL3) of the compensation transistor (T3), especially wherein a channel length (CL3) of the compensation transistor (T3) is greater than a channel length (CL4) of the first initialization transistor (T4).

21. An electronic apparatus comprising a display device (1) according to at least one of claims 1 to 20.
